# FASCICULE DE BREVET EUROPEEN

(11) **EP 2 869 342 B1**
(45) Date de publication et mention de la délivrance du brevet: **06.12.2017**
(21) Numéro de dépôt: 14190748.5
(22) Date de dépôt: 28.10.2014
(51) Int. Cl.: H01L 25/16

(54) **Procédé de fabrication d'un dispositif comprenant un circuit intégré et des cellules photovoltaïques et dispositif**
Verfahren zur Herstellung einer Vorrichtung, die einen integrierten Schaltkreis und Fotovoltaikzellen umfasst und Vorrichtung
Method for manufacturing a device comprising an integrated circuit and photovoltaic cells and device

(30) Priorité: 29.10.2013 FR 1360568
(43) Date de publication de la demande: 06.05.2015
(73) Titulaire: COMMISSARIAT À L'ÉNERGIE ATOMIQUE ET AUX ÉNERGIES ALTERNATIVES, 75015 Paris (FR)
(72) Inventeur: Buckley, Julien, 38000 Grenoble (FR); Ben Jamaa, Haykel, 38000 Grenoble (FR)
(74) Mandataire: Hautier, Nicolas

(56) Documents cités:
- JP-A- H02 111 068
- US-A1- 2012 118 383
- US-A1- 2012 245 444
- US-A1- 2013 260 505
- J. LU ET AL: "Above-CMOS a-Si and CIGS solar cells for powering autonomous microsystems", 2010 INTERNATIONAL ELECTRON DEVICES MEETING, 1 décembre 2010 (2010-12-01), pages 31.3.1-31.3.4, XP055133646, DOI: 10.1109/IEDM.2010.5703457 ISBN: 978-1-44-247418-5
- BELLEW C L ET AL: "An soi process for fabrication of solar cells, transistors and electrostatic actuators", TRANSDUCERS, SOLID-STATE SENSORS, ACTUATORS AND MICROSYSTEMS, 12TH INN ATIONAL CONFERENCE ON, 2003, PISCATAWAY, NJ, USA,IEEE, vol. 2, 9 juin 2003 (2003-06-09), pages 1075-1079, XP010647816, ISBN: 978-0-7803-7731-8
- YUTAKA ARIMA ET AL: "On-chip solar battery structure for CMOS LSI", IEICE ELECTRONICS EXPRESS, vol. 3, no. 13, 1 janvier 2006 (2006-01-01), pages 287-291, XP055133648, DOI: 10.1587/elex.3.287

## Description

### DOMAINE TECHNIQUE DE L'INVENTION

La présente invention concerne en général le domaine des cellules photovoltaïques (PV) et plus particulièrement leur intégration avec des circuits électroniques afin de produire des systèmes électroniques autonomes en alimentation.

### ÉTAT DE LA TECHNIQUE

Pour produire des systèmes électroniques autonomes on utilise le plus souvent des cellules photovoltaïques pour les alimenter. L'industrie de la microélectronique recherchant une toujours plus grande densité d'intégration des dispositifs qu'elle produit, de nombreux procédés de fabrication intégrant cellules PV et circuits électroniques dans un même cycle de fabrication ont ainsi été proposés. Des procédés d'intégration de systèmes autonomes ont par exemple été décrits dans les publications suivantes :
- C.L. Bellew, S. Hollar, K.S.J. Pister, "An SOI process for fabrication of solar cells, transistors and electrostatic actuators", proc. of the 12th International Conférence on Solid State Sensors, Actuators and Microsystems, 2003,
- J. Lu, W. Liu, C.H.M. van der Werf, A.Y. Kovalgin, Y. Sun, R.E.I. Schropp, J. Schmitz, "Above-CMOS a-Si and CIGS Solar Cells for Powering Autonomous Microsystems", Proc. of IEDM 2010, pp. 31.3.1-31.3.4.
- Y. Arima, M. Ehara, "On-chip solar battery structure for CMOS LSI", IEICE Electronics Express, Vol. 3, N°13, pp.287-291, 2006.

Ces publications, qui sont représentatives de l'état de la technique dans le domaine des systèmes autonomes utilisant des cellules photovoltaïques, ont en commun une caractéristique qui est que la réalisation des cellules photovoltaïques est contrainte par le procédé de fabrication des autres composants et notamment par celui des circuits électroniques utilisés, le plus souvent des circuits de type CMOS, la technologie de circuits intégrés la plus largement utilisée, qui est basée sur l'emploi de transistors complémentaires (C) de type métal-oxyde-semi-conducteur (MOS).

Notamment, la fabrication des cellules photovoltaïques est impactée par les contraintes de dopage ou de température du procédé de réalisation du circuit intégré. Ces contraintes tendent à réduire les performances des cellules photovoltaïques.

Dans la publication mentionnée ci-dessus de C.L. Bellew et al., le dopage par implantation des zones N+ et P+ est réalisé en commun pour la cellule photovoltaïque et les zones de source et drain des transistors. Les conditions de dopage employées ne peuvent être alors optimales que pour les transistors ou la cellule photovoltaïque, mais pas pour les deux. Le choix de la technologie de transistors est limité et ne permet pas de fabriquer des circuits complexes employant des noeuds technologiques avancés ou une technologie autre que du CMOS (e.g. bipolaire ou BiCMOS).

Dans la publication mentionnée ci-dessus J. Lu et al., la cellule photovoltaïque employée doit être réalisée avec un budget thermique n'altérant pas le circuit électronique sous-jacent ce qui limite la température de fabrication à environ 500°C. Par ailleurs, son épaisseur ne doit pas dépasser quelques microns pour ne pas contraindre le circuit. Cela empêche l'emploi de cellules photovoltaïques nécessitant des températures de fabrication supérieures à cette valeur ou plus épaisses, ayant un rendement de conversion plus important.

Dans la publication mentionnée ci-dessus Y. Arima et al., la cellule photovoltaïques est constituée de diodes fabriquées avec un procédé CMOS. La géométrie des dopages et de la cellule est ainsi définie selon les contraintes du procédé CMOS lui-même avec notamment des dopages à faible profondeur et une surface de jonction faible par unité de surface. Cela conduit à des cellules de faible rendement, typiquement de l'ordre de 2.6%.

Dans ces conditions, les caractéristiques des cellules photovoltaïques produites ne peuvent être optimales et atteindre des performantes élevées. Cela réduite l'efficacité de l'alimentation électrique des circuits intégrés utilisant les cellules photovoltaïques.

Par ailleurs, les documents US 2012/245444 A1 et US 2013/260505 A1 décrivent d'autres cellules photovoltaïques alimentées par des circuits électroniques.

Un objectif que vise à résoudre la présente invention est d'améliorer l'efficacité de l'alimentation électrique des circuits intégrés utilisant des cellules
photovoltaïques sans pour autant en augmenter significativement le coût de revient ou la complexité.

C'est un objet de l'invention que d'apporter une solution à ce problème.

Les autres objets, caractéristiques et avantages de la présente invention apparaîtront à l'examen de la description suivante et des dessins d'accompagnement. Il est entendu que d'autres avantages peuvent être incorporés.

### RÉSUMÉ DE L'INVENTION

Pour atteindre cet objectif, un mode de réalisation de la présente invention concerne un procédé de fabrication d'un dispositif photovoltaïque comprenant une cellule photovoltaïque ou une pluralité de cellules photovoltaïques (cellules PV) connectées à un circuit intégré électronique présentant au moins une zone de contact électrique. On fabrique un empilement comprenant la ou les cellules PV séparément du circuit intégré électronique, puis on reporte le circuit intégré électronique sur ledit empilement comprenant la ou les cellules PV. Lors de ce report, on met en contact des zones de connexion portées par la ou les cellules PV avec des zones de connexion correspondantes portées par le circuit intégré électronique. L'invention concerne un procédé de fabrication d'un dispositif photovoltaïque comprenant une cellule photovoltaïque ou une pluralité de cellules photovoltaïques (cellules PV) connectées à un circuit intégré électronique, le procédé comprenant les étapes suivantes:
- une étape de réalisation d'un empilement comprenant la cellule ou la pluralité de cellules PV ce qui comprend pour chaque cellule PV la réalisation dans un matériau semi-conducteur d'au moins deux régions présentant des dopages P et N inverses ;
   dans lequel l'étape de réalisation de la cellule ou de la pluralité de cellules PV comprend l'étape suivante au moins, effectuée à partir d'un empilement comprenant: un substrat surmonté d'une couche isolante et d'une couche semi-conductrice, la couche semi-conductrice comprenant au moins une portion supérieure s'étendant depuis une face supérieure de la couche semi-conductrice et présentant un dopage P ou N et une portion inférieure située sous la portion supérieure et présentant un dopage P ou N inverse du dopage de la portion supérieure:
   une étape de formation de la cellule PV ou des cellules PV par gravure de la couche semi-conductrice de manière à former respectivement un ou des îlots séparés les uns des autres, comprenant chacun une superposition des portions inférieure et supérieure de la couche semi-conductrice et présentant une face avant formée par la portion supérieure, chaque îlot formant une cellule PV;
   après l'étape de réalisation de la cellule ou la pluralité de cellules PV, un cycle d'étapes de connexion comprenant au moins la réalisation de premières connexions comportant au moins une zone d'accueil destinées à relier électriquement la au moins une cellule PV avec au moins un circuit intégré électronique, ladite zone d'accueil étant située sur la couche isolante;
- après le cycle d'étapes de connexion, une étape de report, sur ledit empilement comprenant la cellule ou la pluralité de cellules PV, d'un circuit intégré électronique préalablement fabriqué, l'étape de report étant effectuée de manière à connecter électriquement la au moins une zone d'accueil avec une zone de contact électrique portée par le circuit intégré électronique.

Ainsi, l'invention propose un dispositif photovoltaïque co-intégré avec un circuit électronique et procédé de réalisation. L'invention permet de fabriquer séparément le dispositif photovoltaïque et le circuit intégré puis de les assembler sans lourdement complexifier le procédé de fabrication. La fabrication de la ou les cellules PV n'est donc pas contrainte par la fabrication du circuit intégré. On peut ainsi fabriquer des cellules plus performantes ce qui permet d'améliorer l'efficacité énergétique de l'alimentation du circuit intégré. Dans les solutions de l'art antérieur les cellules PV sont réalisées par lithographie de couches successivement déposées sur le circuit intégré, typiquement à partir d'une face avant de ce dernier.

De manière facultative, l'invention peut en outre présenter au moins l'une quelconque des caractéristiques et étapes optionnelles suivantes prises séparément ou en combinaison:
- La zone d'accueil d'un circuit intégré et la zone de contact du circuit intégré électronique comportent généralement, respectivement au moins deux plots de connexion pour relier électriquement ledit circuit intégré à au moins une cellule PV.
- Avantageusement, le dispositif photovoltaïque comprend une pluralité de cellules photovoltaïques (cellules PV) et ledit cycle d'étapes de connexion comprend la réalisation d'une pluralité de deuxièmes connexions électriques pour relier entre elles les cellules PV de ladite pluralité de cellules PV. Dans le cas d'un dispositif comportant une seule cellule PV, le dispositif ne comporte pas de deuxièmes connexions mais uniquement des premières connexions.
- Avantageusement, les étapes de formation des premières connexions et des deuxièmes connexions sont effectuées simultanément. Alternativement, ces étapes sont effectuées successivement.
- Avantageusement, après la gravure de la couche semi-conductrice de manière à former le ou les ilots et avant l'étape de réalisation du cycle d'étapes de connexion électriques, le procédé comprend une étape de formation d'espaceurs uniquement sur les flancs de chaque îlot.
- Les espaceurs sur les flancs d'un même îlot sont contigus.
- Avantageusement, avant l'étape de formation des ilots par gravure de la couche semi-conductrice, la couche semi-conductrice s'étend sur toute la surface du substrat.
- De préférence, avant l'étape de formation des ilots par gravure de la couche semi-conductrice, la couche isolante et la couche semi-conductrice sont planes. De préférence, la couche isolante est au contact de la couche semi-conductrice. De préférence, la couche isolante est au contact du substrat.
- Selon un mode de réalisation, l'étape de formation de chaque ilot par gravure de la couche semi-conductrice est effectuée de manière à conserver au pied de chaque ilot une zone de contact formée dans ladite portion inférieure et qui n'est pas située au droit de ladite portion supérieure.
- Avantageusement, on dope la zone de contact de manière à la rendre électriquement conductrice.
- Avantageusement, le dispositif photovoltaïque comprend une pluralité de cellules PV, ledit cycle d'étapes de connexion comprend la réalisation d'une pluralité de deuxièmes connexions électriques pour relier entre elles les cellules PV de ladite pluralité de cellules PV et l'étape de réalisation d'une pluralité de deuxièmes connexions électriques pour relier entre elles les cellules PV comprend la réalisation d'une connexion électrique connectant la zone de contact d'une cellule PV à ladite face avant d'une autre cellule PV.
- Selon un mode de réalisation, l'étape de formation de chaque ilot par gravure de la couche semi-conductrice est effectuée de manière à stopper la gravure sur la couche isolante en dehors du ou des ilots. Ainsi, en dehors des ilots, la couche semi-conductrice est entièrement gravée.
- Selon un mode de réalisation, le dispositif photovoltaïque comprend une pluralité de cellules PV, ledit cycle d'étapes de connexion comprend la réalisation d'une pluralité de deuxièmes connexions électriques pour relier entre elles les cellules PV de ladite pluralité de cellules PV et la réalisation d'une pluralité de deuxièmes connexions électriques pour relier entre elles les cellules PV comprend les étapes suivantes :
   - gravure, à partir d'une face de l'empilement comportant les cellules PV formées par les ilots, de toute l'épaisseur de la couche isolante et d'une partie de l'épaisseur du substrat pour former une ouverture en dehors de chaque cellule PV. Ainsi cette ouverture n'est pas située au droit de l'ilot.
   - remplissage desdites ouvertures par un matériau conducteur qui est isolé de la paroi de chaque ouverture par un film isolant et formation d'une connexion électrique entre ledit matériau conducteur emplissant l'ouverture et ladite portion supérieure de la couche semi-conductrice et donc de la cellule PV;
   - amincissement de la face arrière du substrat qui est opposée à la face du substrat au regard des cellules PV, jusqu'à faire déboucher sur ladite face arrière les ouvertures emplies de métal qui forment alors des vias traversants ;
   - gravure, au droit des cellules PV et à partir de la face arrière du substrat, de toute l'épaisseur de la couche isolante et du substrat pour former pour chaque cellule PV une ouverture additionnelle, chaque ouverture additionnelle s'étendant depuis la face arrière du substrat et atteignant la portion inférieure de la couche semi-conductrice de chaque cellule PV;
   - remplissage des ouvertures additionnelles par un matériau conducteur qui est isolé de la paroi des ouvertures additionnelles par un film isolant de manière à former des vias connectant la face arrière du substrat à chaque cellule PV ;
   - dépôt sur la face arrière du substrat d'un matériau conducteur pour connecter électriquement chacun desdits vias traversants connectés à la portion inférieure d'une cellule PV à un via connecté à la portion supérieure d'une autre cellule PV.
- Selon un mode de réalisation, le dispositif photovoltaïque comprend une pluralité de cellules PV, ledit cycle d'étapes de connexion comprend la réalisation d'une pluralité de deuxièmes connexions électriques pour relier entre elles les cellules PV de ladite pluralité de cellules PV et la réalisation d'une pluralité de deuxièmes connexions électriques pour relier entre elles les cellules PV comprend les étapes suivantes :
   - gravure, au droit des cellules PV et à partir de la face arrière du substrat, de toute l'épaisseur de la couche isolante et du substrat pour former deux ouvertures pour chaque cellule PV, chaque ouverture s'étendant depuis la face arrière et atteignant la portion inférieure de la couche semi-conductrice de chaque cellule PV;
   - dopage, pour chaque cellule PV, d'une zone de la portion inférieure sur laquelle débouche l'une des deux ouvertures, ce dopage étant inverse de celui de la portion inférieure ;
   - remplissage pour chaque cellule PV des deux ouvertures par un matériau conducteur de manière à former des vias connectant la face arrière du substrat à chaque cellule PV;
   - formation sur la face arrière du substrat de connexions électriques de manière à connecter électriquement deux à deux des via associés à deux cellules PV et débouchant sur des zones de la portion inférieure présentant des dopages inverses.
- De préférence, après la gravure des deux ouvertures pour chaque cellule PV et avant le remplissage pour chaque cellule PV des deux ouvertures par un matériau conducteur, on effectue une étape de dopage, pour chaque cellule PV, d'une zone de la portion inférieure sur laquelle débouche l'autre des deux ouvertures, ce dopage étant inverse de celui de la portion inférieure et présente un niveau de dopage au moins 10 fois et de préférence au moins 100 fois plus élevé que celui de la portion inférieure.
- Avantageusement, la réalisation d'au moins des premières connexions comportant une zone d'accueil pour un circuit intégré comprend la réalisation :
   - d'au moins une zone d'accueil située sur la couche isolante pour recevoir un premier circuit intégré sur la face de la couche isolante tournée au regard de ou les cellules PV ;
   - d'au moins une zone d'accueil située sur la face arrière du substrat pour recevoir un premier circuit intégré sur ladite face arrière.
- Selon un mode de réalisation, l'empilement comprenant un substrat surmonté d'une couche isolante et d'une couche semi-conductrice est un substrat de type silicium sur isolant (SOI) dans lequel la couche isolante est formée d'un oxyde de silicium. On effectue, à partir du substrat SOI, une étape de dopage de la face supérieure de la couche semi-conductrice de manière à ce que la couche semi-conductrice comprenne ladite portion supérieure qui s'étend depuis sa face supérieure et qui présente un dopage inverse de celui de ladite portion inférieure formée par le reste de la couche semi-conductrice.
- Alternativement, l'empilement comprenant un substrat surmonté d'une couche isolante est obtenu en effectuant les étapes suivantes à partir d'un substrat massif en un matériau semi-conducteur:
   - dopage de type N ou P d'une partie supérieure du substrat massif pour former la couche isolante dudit empilement;
   - report sur la partie supérieure d'une couche semi-conductrice présentant un dopage inverse de celui de la partie supérieure du substrat massif ;
   - amincissement de ladite couche semi-conductrice reportée ;
   - dopage de la face supérieure de ladite couche semi-conductrice reportée de manière à ce que cette couche semi-conductrice reportée présente une portion supérieure qui s'étend depuis sa face supérieure et qui présente un dopage inverse d'une portion inférieure formée par le reste de ladite couche semi-conductrice reportée.
- Selon un mode de réalisation, ladite portion inférieure est formée d'une première portion d'épaisseur présentant un dopage P ou N et d'une autre portion d'épaisseur également dopée P respectivement N mais dont le niveau de dopage est au moins 100 fois supérieur à celui de la première portion et est au moins égal à 1 atome de l'espèce dopante pour moins de 1000 atomes du matériau formant la couche semi-conductrice (dopage P+ respectivement N+), ladite autre portion étant située entre la couche isolante et ladite première portion d'épaisseur dopée P respectivement N et dans lequel ladite autre portion d'épaisseur est au contact de la couche isolante et de ladite première portion d'épaisseur.
- Avantageusement, la portion d'épaisseur dopée P+ est au contact de la couche isolante et de la portion d'épaisseur dopée P. Ainsi, la couche semi-conductrice est ainsi une couche double. Cela a notamment pour avantage d'offrir une meilleure résistance d'accès aux zones P des cellules PV.
- Avantageusement, le report du circuit intégré électronique entraîne à lui seul la connexion entre ce dernier et au moins certaines des cellules PV.
- Selon un mode de réalisation, le dispositif photovoltaïque comprend une pluralité de cellules PV, ledit cycle d'étapes de connexion comprend la réalisation d'une pluralité de deuxièmes connexions électriques pour relier entre elles les cellules PV de ladite pluralité de cellules PV et préalablement à l'étape de formation des ilots par gravure de la couche semi-conductrice pour former les cellules PV on dispose sous la couche semi-conductrice une couche isolante et on forme à l'intérieur de la couche isolante et pour chaque cellule PV une plage conductrice, connectée à la portion inférieure de la couche semi-conductrice de la cellule PV et s'étendant latéralement de manière à présenter au moins une première portion située au droit de la cellule PV et au moins une deuxième portion non située au droit de cette même cellule PV. La réalisation d'une pluralité de deuxièmes connexions électriques pour relier entre elles les cellules PV comprend les étapes suivantes :
   ouverture de la couche isolante au droit de la deuxième portion de la plage métallique de la cellule PV, dépôt d'un matériau conducteur dans l'ouverture et sur une partie du flanc d'une autre cellule PV jusqu'à atteindre la portion supérieure de cette autre cellule PV, de manière à réaliser une connexion électrique entre la portion inférieure et la portion supérieure de deux cellules PV.
- Le circuit intégré électronique comprend des transistors complémentaires (C) de type métal-oxyde-semi-conducteur (MOS). Plus généralement, dans la présente demande de brevet, un circuit intégré est un circuit comprenant des transistors notamment des transistors complémentaires (C) de type métal-oxyde-semi-conducteur (MOS) et/ou des mémoires et/ou des batteries et/ou des dispositifs passifs, par exemple capacités ou des inductances.

Selon un autre mode de réalisation, le procédé comprend les étapes suivantes:
- une étape de réalisation de la pluralité de cellules PV à la surface d'un empilement; ce qui comprend pour chaque cellule PV la réalisation dans un matériau semi-conducteur d'au moins une et de préférence d'au moins deux régions en contact présentant des dopages P ou N inverses et supportées par un substrat de support ;
- après l'étape de réalisation de la pluralité de cellules PV, un cycle d'étapes de connexion comprenant :
   - la réalisation d'au moins une première connexion formant une zone d'accueil configurée pour relier électriquement au moins une cellule PV avec au moins un circuit intégré électronique;
   - la réalisation d'une pluralité de deuxièmes connexions électriques pour relier entre elles les cellules PV de ladite pluralité de cellules PV ;
- après le cycle d'étapes de connexion, une étape de report, sur ledit empilement comprenant la pluralité de cellules PV, d'un circuit intégré électronique fabriqué préalablement à l'étape de report, l'étape de report étant effectuée de manière à connecter électriquement au moins une zone d'accueil avec une zone de contact électrique portée par le circuit intégré électronique.
Le dispositif selon la présente invention est un dispositif photovoltaïque comprenant une ou plusieurs cellules photovoltaïques (cellules PV) et au moins un circuit intégré électronique connecté à la cellule PV ou à la pluralité de cellules PV, le dispositif comprenant: un substrat surmonté d'une couche isolante et une couche semi-conductrice disposée sur une face avant de la couche isolante, la cellule PV ou la pluralité de cellules PV étant formée dans ladite couche semi-conductrice; ladite face avant de la couche isolante portant des connexions électriques formant au moins une zone d'accueil configurée pour connecter au moins une cellule PV avec au moins un circuit intégré électronique; ledit au moins un circuit intégré électronique étant disposé au contact de et sur la zone d'accueil au regard de la face avant de la couche isolante; ladite zone d'accueil permettant de connecter à elle seule au moins une cellule PV avec l'au moins un circuit intégré électronique. Ainsi, les cellules PV et le circuit intégré électronique sont disposés au regard de la face avant de la couche isolante.

De manière optionnelle, le dispositif photovoltaïque comprend une pluralité de cellules PV et dans lequel ladite face avant de la couche isolante porte des connexions électriques pour relier entre elles les cellules PV de ladite pluralité de cellules PV.

De manière optionnelle, le dispositif photovoltaïque comprend un circuit intégré électronique additionnel disposé au regard d'une face arrière du substrat, connecté à la ou les cellules PV de manière à ce que ladite couche isolante soit disposée entre deux circuits intégrés électroniques. Cette structure a notamment pour avantage de permettre une grande capacité d'intégration. Ladite zone d'accueil permet de connecter à elle seule le circuit intégré électronique avec au moins certaines des cellules PV. Ainsi, il n'y a pas besoin de connexion additionnelle, par exemple par un câble électrique ou un fil électrique.

Un équipement microélectronique comprenant au moins un dispositif photovoltaïque selon l'invention est réalisable. Par équipement microélectronique, on entend tout type d'équipement réalisé avec des moyens de la microélectronique. Ces équipements englobent notamment en plus des dispositifs à finalité purement électronique, des dispositifs micromécaniques ou électromécaniques (MEMS, NEMS...) ainsi que des dispositifs optiques ou optoélectroniques (MOEMS...)

### BRÈVE DESCRIPTION DES FIGURES

Les buts, objets, ainsi que les caractéristiques et avantages de l'invention ressortiront mieux de la description détaillée d'un mode de réalisation de cette dernière qui est illustré par les dessins d'accompagnement suivants dans lesquels :
Les FIGURES 1a à 1h illustrent un premier mode de réalisation de l'invention dans lequel on réalise un ou plusieurs îlots de cellules photovoltaïques (PV) et les connexions métalliques entre les cellules PV à la surface d'un substrat pouvant accueillir un circuit intégré.
Les FIGURES 2a à 2d illustrent une variante du mode de réalisation précédent qui ne nécessite pas de partir d'une structure silicium sur isolant (SOI).
La FIGURE 3 illustre une option supplémentaire du premier mode de réalisation de l'invention.
Les FIGURES 4a à 4j décrivent un premier mode de réalisation de l'invention qui intègre des connexions traversantes verticales de type TSV.
Les FIGURES 5a à 5h décrivent un troisième mode de réalisation de l'invention dans lequel les ilots PV sont interconnectés à l'aide de TSV par la face arrière.
Les FIGURES 6a à 6i décrivent un quatrième mode de réalisation de l'invention.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier les épaisseurs relatives des différentes couches et films ne sont pas représentatifs de la réalité.

### DESCRIPTION DÉTAILLÉE DE L'INVENTION

Il est précisé que dans le cadre de la présente invention, le terme « sur », « surmonte », « recouvre » ou « sous-jacent » ou leurs équivalents ne signifient pas « au contact de ». Ainsi par exemple, le dépôt d'une première couche sur une deuxième couche, ne signifie pas obligatoirement que les deux couches sont directement au contact l'une de l'autre mais cela signifie que la première couche recouvre au moins partiellement la deuxième couche en étant soit directement à son contact soit en étant séparée d'elle par au moins une autre couche ou au moins un autre élément.

Dans la présente invention des types de dopage P ou N seront indiqués. Ces dopages sont des exemples non limitatifs. L'invention couvre tous les modes de réalisation dans lesquels les dopages sont inversés. Ainsi, si un exemple de réalisation mentionne pour une première zone un dopage P et pour une deuxième zone un dopage N, la présente description décrit alors, implicitement au moins, l'exemple inverse dans lequel la première zone présente un dopage N et la deuxième zone un dopage P.

De manière conventionnelle, un dopage noté P+ signifie qu'il s'agit d'un dopage de type P (dopage par des charges positives) et dont la teneur en espèce dopante est supérieure ou égale à 1 atome de l'espèce dopante pour moins de 1000 atomes du semi-conducteur et de préférence pour moins de 10 à 100 atomes du matériau formant la couche semi-conductrice. De même, un dopage N+ signifie qu'il s'agit d'un dopage de type N (dopage par des charges négatives) et dont la teneur en espèce dopante est supérieure ou égale à 1 atome de l'espèce dopante pour moins de 1000 atomes du semi-conducteur et de préférence pour moins de 100 à 1000 atomes du matériau formant la couche semi-conductrice.

Dans la présente demande de brevet, un dopage noté P englobe tous les dopages par porteurs de charges positives quelle que soit la teneur du dopage. Ainsi, un dopage P comprend les teneurs en dopage P+ et les teneurs en dopage P inférieures au dopage de type P+. De même, un dopage noté N englobe tous les dopages par porteurs de charges négatives quelle que soit la teneur du dopage. Ainsi, un dopage N comprend les teneurs en dopage N+ et les teneurs en dopage N inférieures au dopage de type N+.

Dans la présente demande de brevet, l'épaisseur est prise selon une direction perpendiculaire aux faces principales du substrat sur lequel repose les différentes couches. Sur les figures, l'épaisseur est prise selon la verticale.

De même lorsqu'on indique qu'un élément est situé au droit d'un autre élément, cela signifie que ces deux éléments sont situés tous deux sur une même ligne perpendiculaire au plan principal du substrat, soit sur une même ligne orientée verticalement sur les figures.

L'invention décrit un procédé qui permet de réaliser les cellules photovoltaïques séparément, sans avoir à subir les contraintes de fabrication des autres circuits, typiquement celles d'un circuit intégré de type CMOS, tout en permettant un assemblage très dense des composants formant le système autonome produit.

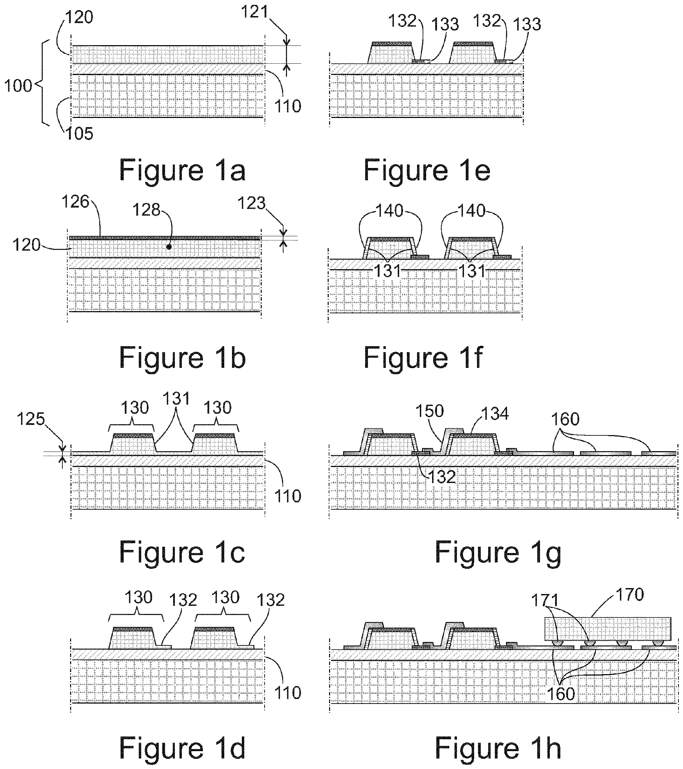

Les **figures 1a à 1h** décrivent un premier mode de réalisation de l'invention où l'on réalise, d'une part, un ou plusieurs îlots de cellules photovoltaïques (PV), et d'autre part, les connexions métalliques entre les cellules PV en surface. Ce mode de réalisation offre l'avantage de pouvoir connecter sans contrainte les cellules PV en série et en parallèle afin d'optimiser, en fonction de l'application visée, la tension de sortie du système PV ainsi réalisé, le courant fourni et son rendement. Le coût est faible car toutes les connexions métalliques sont réalisées avec les procédés standards de l'industrie du semi-conducteur lors des opérations dites BEOL, acronyme de l'anglais « back-end of line » faisant référence aux opérations de « fin de ligne » de production au cours desquelles on réalise les interconnexions métalliques entre les composants des dispositifs produits. En termes de surface la solution est aussi compacte puisqu'elle bénéficie des progrès de l'industrie du semi-conducteur qui améliore constamment l'intégration des dispositifs produits.

La figure 1a montre le point de départ de ce premier mode de réalisation qui est un substrat élaboré de type SOI 100, acronyme de l'anglais « silicon on insulator » c'est-à-dire « silicium sur isolant ». Ce type de substrat, qui est produit de façon classique par l'industrie du semi-conducteur, comprend en effet une « couche d'oxyde enterrée» dite « BOX » 110, acronyme de l'anglais « buried oxide layer ».

Ce type de substrat permet la réalisation des composants dans la couche de silicium 120 de préférence monocristallin située au-dessus de la couche d'oxyde 110. Les couches supérieures, 110 et 120 du substrat SOI 100 reposent sur un substrat massif dit « bulk » 105 qui confère à l'ensemble les propriétés mécaniques nécessaires pour qu'il puisse être manipulé sans difficulté dans une ligne de production de type de celles mise en oeuvre par l'industrie du semi-conducteur.

Dans cet exemple non limitatif, la couche de silicium 120 est dopée de type « P ». Elle est d'une épaisseur 121 comprise dans une gamme allant de 10 à 160 µm (1 µm ou micron = 10⁻⁶ mètre). Elle est de préférence d'une épaisseur de 80 µm.

Si on ne dispose pas d'un substrat SOI répondant aux spécifications ci-dessus, il est possible de partir d'un substrat simple de type « bulk » qui aura été oxydé en surface. On peut alors reporter par collage un autre substrat « bulk », dopé de type P, qui aura également été préalablement oxydé en surface. On réalise ainsi un collage moléculaire entre les deux couches d'oxyde. On procède ensuite à l'amincissement du substrat reporté pour ne laisser en place qu'une épaisseur allant de 10 à 160 µm de silicium de type P, et de préférence, comme ci-dessus, une épaisseur de 80 µm. Cette technique permet de reconstituer un substrat SOI adapté équivalent à la structure 100 à partir de deux substrats « bulk ».

Quel que soit le mode d'obtention du substrat formant la structure 100, comme montré sur la figure 1b, on effectue ensuite un dopage de type « N » par implantation ionique et recuit de diffusion sur une profondeur 123 de la couche 120, à partir de la surface. Par exemple, cette profondeur est dans une gamme d'épaisseur allant de 0,5 à 5 µm. On crée ainsi une interface continue de type diode PN dans laquelle on va ensuite venir former les cellules PV.

La portion dopée N+ est référencée 126 et la portion dopée P est référencée 128 en figure 1b.

Pour ce faire, comme illustré sur la figure 1c, la couche 120 est structurée de façon conventionnelle par lithographie et gravure en vue d'isoler des îlots 130 de cellules PV. Dans la présente description, on qualifiera de structuration une série d'étapes permettant d'obtenir dans une couche un motif en saillie ou en creux, ces étapes comprenant une lithographie impliquant par exemple le dépôt d'une couche de résine, la définition d'ouvertures dans la résine, à travers un masque par exemple, puis une gravure à travers les ouvertures.

En l'absence de couche d'arrêt sélective, l'arrêt de la gravure se fait, à cette étape du procédé, au temps, pour laisser en dehors des ilots 130 une épaisseur résiduelle 125 de la couche 120 allant de 0,1 à 10 µm, au-dessus de la couche d'oxyde enterrée (BOX) 110. La gravure peut être de type dit « humide », par exemple à l'aide d'une solution à base d'hydroxyde de potassium (KOH) auquel cas la gravure est isotrope et on obtient, comme représenté, des flancs inclinés. L'inclinaison de ces flancs provient du fait que certaines gravures humides, telle que celle à base de KOH, suivent des directions préférentielles des plans cristallins du Silicium au fur et à mesure de l'avancement de gravure. Vu de dessus, le motif de gravure obtenu à partir d'une ouverture, par exemple, carrée dans la résine, est également un carré dont la surface diminue au fur et à mesure que la gravure gagne de la profondeur. Le taux de diminution est donné par l'inclinaison du plan cristallin préférentiel de la gravure par rapport au plan de la plaque. Vue en coupe, le motif de gravure est donc un trapèze avec des flancs inclinés et linéaires reflétant l'angle préférentiel de gravure. Au niveau des pieds des motifs, on obtient macroscopiquement un angle solide obtus reflétant le croisement des deux plans de gravure préférentiels voisins. On peut aussi utiliser une gravure dite « sèche », de type plasma, qui est anisotrope pour obtenir des flancs perpendiculaires au plan du substrat.

La figure 1d montre le résultat de l'étape suivante où la couche 120 est structurée plus avant, par lithographie et gravure conventionnelles comme ci-dessus, afin de finir d'isoler complètement les îlots 130 les uns des autres. L'arrêt de la gravure peut se faire à cette étape par détection de sur la couche BOX 110. La lithographie et la gravure sont effectuées de manière à laisser en place une zone de contact 132 avec chaque îlot. On notera ici que l'isolation entre ilots est assurée par la couche BOX 110 sur laquelle repose tous les ilots PVD 130.

À l'étape suivante, dont le résultat est illustré sur la figure 1e, les zones de contact 132 sont dopées. Pour cela, la couche 120 est structurée à nouveau par lithographie pour permettre de doper 133 les zones de contact 132 des îlots. Le dopage est de type P⁺, c'est-à-dire qu'il correspond à un fort niveau de dopage qui permet d'assurer une faible résistance électrique de ces zones de contact. Un recuit de diffusion est pratiqué après l'étape de dopage.

On procède ensuite au dépôt « pleine plaque » d'un isolant sur toute la surface du substrat lequel est gravé de manière anisotrope pour former des espaceurs 140 sur les flancs 131 des îlots. Le résultat de ces opérations est illustré par la figure 1f. Dans certains cas, l'angle des flancs inclinés risque de défavoriser la définition des espaceurs réguliers, qui pourraient être gravés en même temps que le reste de la couche d'isolant pendant la gravure anisotrope. Dans ce cas, il est possible de définir des motifs de lithographie en résine qui couvrent les flancs pendant la gravure, et qui permettent de cibler la gravure de la couche isolant sur toute la plaque en excluant les espaceurs sur les flancs.

On dépose ensuite un métal qui est structuré de façon conventionnelle par lithographie et gravure pour réaliser, comme représenté sur la figure 1g, des connexions 150 qui relient les zones N 134 et P 132 de deux îlots différents et les connectent ainsi en série. Des ilots peuvent aussi être connectés en parallèle en reliant séparément les zones N et les zones P de deux îlots différents.

De manière particulièrement avantageuse, au cours de cette étape on réalise aussi des zones d'accueil 160 également désignées plots d'accueil 160. Ces zones d'accueil 160 sont destinées à accueillir un circuit intégré électronique externe 170, par exemple de type CMOS, qui pourra être connecté au dispositif PV que l'on vient de décrire. Une ou plusieurs zones d'accueil suffisent à connecter électriquement un circuit électrique 170 avec des cellules PV, sans qu'il y ait besoin d'élément de connexion additionnel ou intermédiaire tel qu'un câble électrique. Alternativement, ces zones d'accueil 160 peuvent être réalisées avant ou après la formation des connexions 150 reliant les cellules PV entre elles. Néanmoins, ces zones d'accueil 160 tout comme les connexions 150 reliant les cellules PV entres elles sont réalisées après formation des cellules PV.

Dans la présente invention, les connexions formant les zones d'accueil pour la connexion d'une ou plusieurs cellules PV avec le circuit intégré sont qualifiées de premières connexions et les connexions électriques pour relier entre elles les cellules PV sont qualifiées de deuxièmes connexions.

La figure 1h montre comment un circuit intégré externe 170 peut être reporté sur le substrat contenant les îlots photovoltaïques en utilisant, par exemple, comme représenté, la technique dite « flipchip » (puce retournée en français) ou en employant toute autre technique de report et de connectique, telle que celle dite de « wire-bonding » (câblage par fil en français). Ces techniques sont bien connues de l'homme du métier et de pratique courante dans l'industrie de la microélectronique.

Avantageusement, le circuit intégré électronique 170 est fabriqué indépendamment du dispositif PV comprenant le substrat 105 et les cellules PV. Le circuit intégré 170 peut être fabriqué avant, pendant ou après la fabrication du dispositif PV. Il est mécaniquement rapporté et électriquement connecté sur ce dernier au niveau des zones d'accueil 160 portées par le circuit intégré 170. Typiquement le circuit intégré 170 comprend des plots de contact 171 complémentaires des zones d'accueil 160. Dans l'exemple illustré, les plots de contact 171 portés par le circuit intégré électronique 170 sont par exemple des pad ou des billes métalliques, par exemple en indium ou en étain ou en cuivre, ou en alliage de cuivre, argent et étain, avec en option une finition anticorrosion telle que de l'or ou du nickel. Ils sont par exemple aptes à fondre ou à adhérer aux zones de contact 160 par refusion. En fonction du type de métal et de finition des contacts 171, les contacts 160 sont réalisés et préparées pour pouvoir héberger les contacts 171.

On obtient ainsi un dispositif comprenant le circuit intégré 170 et le dispositif PV d'une manière simple et reproductible et sans pour autant que la fabrication du dispositif PV n'ait été contrainte par la fabrication du circuit intégré 170.

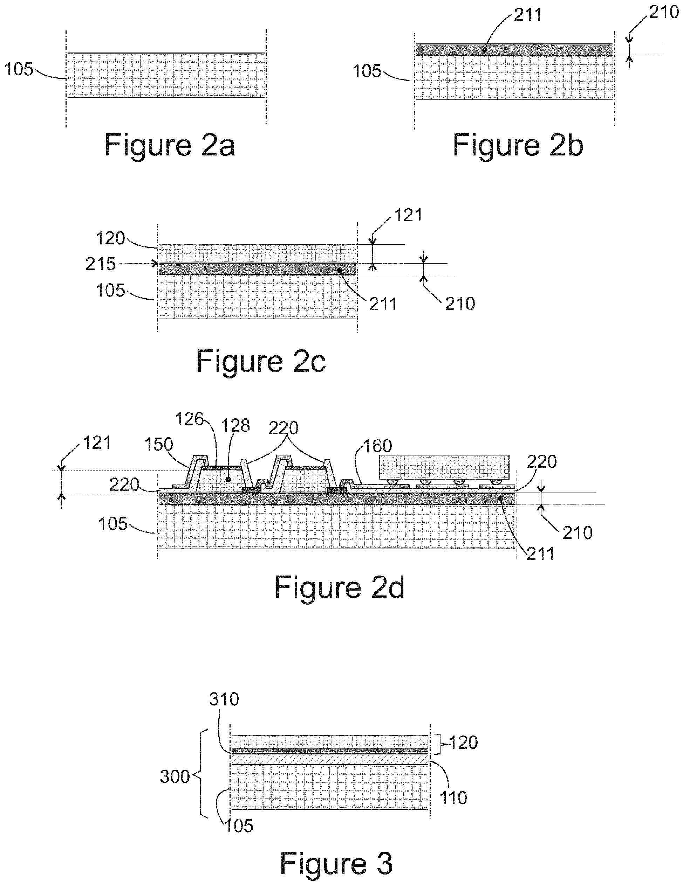

Une variante de la mise en oeuvre précédente de l'invention, qui ne nécessite pas de partir d'une structure SOI telle que 100, est décrite dans les **figures 2a à 2d****.**

Comme montré sur la figure 2a le point de départ est alors un simple substrat de type « bulk » 105.

On procède ensuite, comme montré sur la figure 2b, à un dopage de type N en surface du substrat 105. Le dopage est effectué sur une profondeur 210 allant de 0,1 à 10 µm après recuit de diffusion. La partie dopée N est référencée 211 en figure 2b.

À l'étape suivante, dont le résultat est illustré sur la figure 2c, on reporte un autre substrat de type « bulk » dopé P. L'assemblage des deux substrats est obtenu ici aussi par collage moléculaire à l'interface 215. Ensuite, le substrat reporté est aminci pour ne laisser, comme précédemment, qu'une couche 120 de silicium de type P d'une épaisseur 121 allant par exemple de 10 à 160 µm et de préférence d'une épaisseur de 80 µm.

Les étapes correspondant aux figures 1b à 1e sont ensuite exécutées comme décrit dans ces figures. À l'issue de l'étape correspondant à la figure 1e, en remplacement de l'étape correspondant à la figure 1f où l'on formait les espaceurs, on réalise un dépôt d'isolant 220 et sa structuration par lithographie pour ouvrir des contacts au niveau des zones N et P de silicium des îlots. La structure finale obtenue est celle représentée sur la figure 2d. Dans cette structure, les espaceurs, ayant une fonction d'isolation électrique, sont définis en même temps que le reste de l'isolation de la structure, pour ne garder que les ouvertures de contact comme points d'accès électriques.

A partir de de la figure 2c, il faut d'abord effectuer l'étape 2d, avec dépôt de l'isolant 220 avant de reprendre les étapes 1f à 1h. En effet, dans l'étape 1f les îlots de PV sont isolés électriquement « en bas » par la couche 110 qui est un oxyde. Dans l'étape 2d, les cellules PV sont isolées électriquement « en bas » par une jonction n-p inversée (couches 211 et 128). Un métal déposé par-dessus directement (tel que 150 par exemple) causerait des courants de fuites et des potentiels indésirables vers la couche 211. D'où l'intérêt d'une isolation globale telle que décrite dans les étapes 2d.

On remarquera ici que pour cette variante de mise en oeuvre de l'invention, qui ne nécessite pas de partir d'une structure SOI, les cellules PV, au lieu d'être isolées du silicium du substrat par la couche BOX 110, le sont par la zone désertée de charge à l'interface entre la couche de silicium dopée de type N 210 et celle 120 dopée de type P au-dessus, d'épaisseur 121. Pour créer la zone désertée dans ce cas, il est préférable d'appliquer un potentiel positif sur la couche N, c'est-à-dire plus élevé que celui de la couche P située au-dessus, soit à l'aide de contacts dédiés, non représentés sur la figure 2d mais qui peuvent réalisés par des étapes de contact standard, soit par le biais du substrat en silicium 105.

La **figure 3** illustre une option supplémentaire du premier mode de réalisation de l'invention, décrit ci-dessus dans les figures 1 et 2.

Dans cette option la structure SOI de départ 300 comprend une couche supérieure de silicium 120, c'est-à-dire la couche de type P dans laquelle on réalise les ilots photovoltaïques, qui est double et inclut une couche fortement dopée 310, de type P⁺, qui vient en contact avec la couche BOX 110. Cette structure plus complexe, qui offre une meilleure résistance d'accès aux zones P des cellules PV, peut être réalisée par report de couches successives et collages moléculaires ou par épitaxie.

D'une manière alternative, on peut aussi partir d'un substrat « bulk » dopé de type N en surface, comme décrit dans la figure 2b, sur lequel on reporte une couche double, P sur P⁺. La couche P⁺ est alors, dans ce cas, en contact avec la couche 210, de type N, du substrat. Alternativement, comme ci-dessus, on peut réaliser les couches P et P⁺ par épitaxie.

Dans chacune des options ci-dessus il n'est plus alors nécessaire de définir les zones de contact 132, de type P⁺ par gravure, sans couche d'arrêt, suivie d'un dopage et d'une diffusion des dopants, comme décrit dans la figure 1^{e}. En effet dans ce cas la couche P⁺ est déjà présente sur toute la surface de la base de chacun des îlots PV et pas seulement sur une extrémité comme représenté dans les figures 1 et 2.

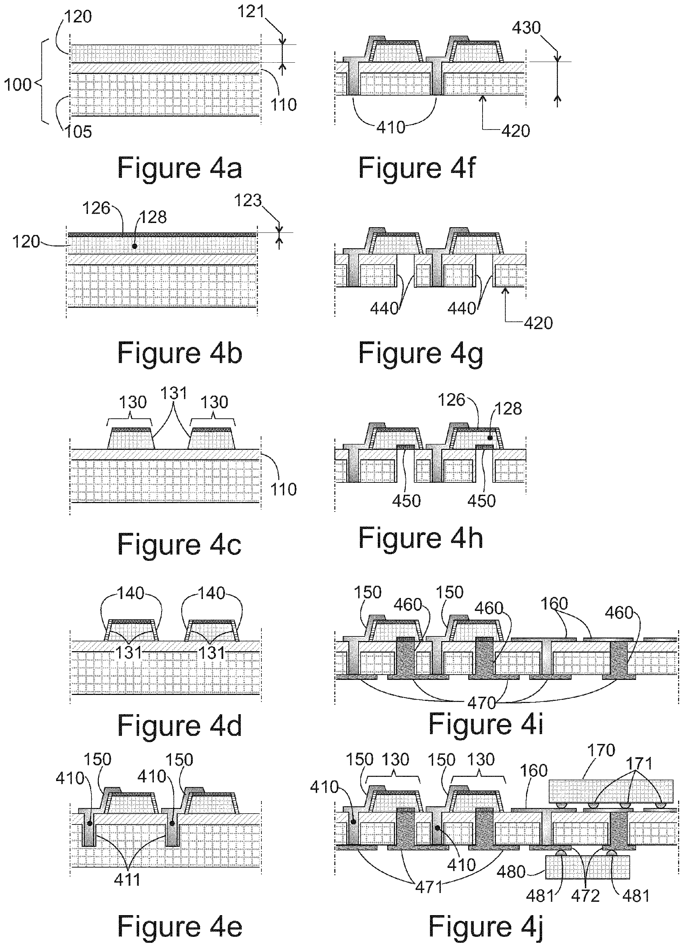

Les **figures 4a à 4j** décrivent un premier mode de réalisation de l'invention qui intègre des connexions traversantes verticales de type TSV, acronyme de l'anglais « through silicon vias », qui fait référence à une technique développée par l'industrie du semi-conducteur pour connecter un empilement de puces à l'aide de vias capables de traverser l'épaisseur d'un substrat. Ce mode de réalisation apporte notamment les avantages suivants :
- L'assemblage du circuit intégré externe peut se faire sur la face inférieure du substrat si nécessaire.
- La connexion entre les zones P et N de deux cellules PV peut se faire par l'intermédiaire de vias traversants (TSV).

Ce premier mode de réalisation peut être plus compact que le mode décrit dans les figures précédentes en fonction du diamètre des TSV réalisés. Il présente aussi l'avantage de ne pas nécessiter la gravure sans couche d'arrêt utilisée pour définir les zones de contact 132 dans les figures 1d et 1e du premier mode de réalisation. De plus, ce mode de réalisation, offre la possibilité d'héberger un ou plusieurs circuits externes placés sur l'une ou les deux faces du substrat.

La figure 4a montre le substrat de départ qui est, comme précédemment, un substrat 100 de type SOI comprenant une couche 120 de silicium dopé P d'une épaisseur 121 allant de 10 à 160 µm, et de préférence d'une épaisseur de 80 µm.

De manière identique au premier mode de réalisation on effectue, comme montré sur la figure 4b, un dopage de type N de la couche 120 par implantation ionique et recuit de diffusion sur une profondeur 123 allant de 0,5 à 5 µm. La portion dopée N est référencée 126 et la portion dopée P est référencée 128 en figure 4b.

Comme montré sur la figure 4c la couche 120 est structurée par lithographie et gravée pour réaliser les îlots 130 de cellules PV. Dans ce cas l'arrêt de la gravure se fait sur la couche BOX 110. Comme précédemment, la gravure peut être de type « humide » et utiliser, par exemple, une solution à base de KOH, auquel cas la gravure est isotrope et on obtient, comme représenté, des flancs inclinés 131. La gravure peut aussi être « sèche » et anisotrope auquel cas on obtient des flancs perpendiculaires au plan du substrat.

La figure 4d illustre la réalisation des espaceurs 140. Comme décrit précédemment dans la figure 1f on dépose une couche d'un isolant sur toute la surface du substrat puis on la grave de manière anisotrope pour former les espaceurs 140 sur les flancs 131 des îlots.

L'étape suivante, dont le résultat est illustré sur la figure 4e, consiste à réaliser, à partir de la face avant, des vias qualifiés ci-après « TSV middle » ou de « TSV intermédiaires » 410. Pour ce faire, on réalise une gravure profonde dans le silicium destinée à héberger les TSV en cours de réalisation. Cette gravure profonde est réalisée selon une direction perpendiculaire au substrat et entre les ilots 130. Un isolant est ensuite déposé de manière conforme, c'est-à-dire à l'aide d'une méthode qui permet de déposer une épaisseur sensiblement identique quelle que soit l'orientation de la surface sur laquelle le dépôt a lieu. Une couche isolante 411 recouvre ainsi le flanc de la gravure. Ensuite, une ou plusieurs étapes de gravures sont réalisées pour dégager l'isolant se trouvant au niveau des zones N, et préférentiellement aussi l'isolant qui se trouve au fond des vias des « TSV intermédiaire ». Cette étape peut être réalisée avec ou sans lithographie. Dans ce dernier cas, elle est connue sous le nom de « etch back ». Une gravure de type « etch-back » est réalisée sur une surface possédant une topologie donnée et couverte d'une couche. La topologie fait que la gravure n'agit pas de la même manière au fond et sur les bords des cavités. En optimisant les paramètres du procédé de gravure, il est ainsi possible de graver la couche du fond de la cavité tout en laissant au moins une partie de la couche sur les bords de la cavité.

Les TSV sont ensuite remplis de métal, par exemple du cuivre (Cu). L'utilisation de cuivre fait que des couches anti-diffusions, non représentées, peuvent avoir à être déposées entre le métal du TSV et son isolant. Les TSV et les lignes métalliques latérales 150, 160 peuvent être structurées pendant cette étape par une technique dite de « lift-off », technique pratiquée couramment par l'industrie du semi-conducteur qui consiste à « soulever » le métal qui ne doit pas rester en place lors de la formation des lignes métalliques. Les lignes métalliques latérales 150, 160 sont respectivement les connexions 150 entre une cellule PV et un TSV et une zone d'accueil 160 pour la réception d'un circuit externe 170.

À l'étape suivante, illustrée par la figure 4f, le substrat est collé sur une poignée de manipulation temporaire, non représentée, et est aminci par la face arrière 420 jusqu'à ce que les « TSV middle » 410 débouchent sur cette face. L'épaisseur finale 430 peut être comprise dans une gamme d'épaisseur allant de 1 à 300 µm.

Ensuite, comme illustré sur la figure 4g, une gravure profonde est réalisée à partir de la face arrière 420. Cette gravure profonde est réalisée selon une direction perpendiculaire au substrat et au droit des ilots 130 de manière à parvenir aux ilots 130. De préférence une gravure parvient à chaque ilot. Un isolant est déposé et gravé de manière anisotrope à l'aide d'une gravure dite « etch-back », pour ne garder l'isolant que sur les flancs verticaux 440.

À l'étape suivante, dont le résultat est illustré par la figure 4h, une implantation est réalisée par la face arrière afin d'effectuer un dopage de type P⁺ des zones 450 qui permettront d'établir un bon contact électrique avec la zone P des ilots PV. Une activation, le fait de rendre des dopants électriquement actifs dans un semi-conducteur, peut être faite par laser ou fast-annealing signifiant recuit rapide. Pour procédé à cette activation dans le fond des trous, un mode de réalisation consiste à exposée brièvement la surface inférieure à un rayon laser puissant qui chauffe la surface localement à des températures élevées et sur des profondeurs moins de 5 µm, ou moins de 100 nm. La fusion locale de la surface active les dopants. Cette étape peut également faire fondre sur la surface le cuivre des structures 410. Si l'environnement dans la chambre du procédé est sec et dépourvu d'oxygène, les structures 410 ne sont pas impactées par cette activation. Dans le cas contraire, elles risquent de s'oxyder légèrement sur la surface, auquel cas, il faudra prévoir une étape de désoxydation du cuivre 410 par gravure d'oxyde de cuivre de courte durée.

Comme montré sur la figure 4i on procède ensuite, par la face arrière 420, au remplissage des gravures profondes qui ont été effectuées depuis cette face afin de former de nouveaux TSV, qualifiés de « TSV last » 460. Des lignes d'interconnexion métalliques 470 sont possiblement réalisées simultanément sur la face arrière. La structuration des TSV et des lignes métalliques peut être faite par « lift-off ». Certaines des interconnexions métalliques 470 servent à connecter électriquement les cellules PV entre elles, ces interconnexions métalliques sont référencées 471. Plus précisément chaque connexion 471 s'étend dans un plan sensiblement parallèle à la surface du substrat et relie électriquement un TSV middle connecté à un premier ilot 130 à un TSV last connecté à un premier ilot 130 qui est de préférence adjacent au premier ilot 130.

D'autres parmi les interconnexions métalliques 470 forment des zones d'accueil 472 pour connecter électriquement les cellules PV avec un circuit intégré externe 480 rapporté sur la face arrière du substrat 105.

La figure 4j illustre le fait que des circuits intégrés, 170 et 480, peuvent alors être reportés, optionnellement, sur les deux faces de l'empilement contenant les îlots photovoltaïques 130. Ceci peut se faire par exemple en utilisant, comme représenté, la technique dite « flipchip » ou à l'aide de toute autre technique de report et de connectique telle que le « wire-bonding ».

Les techniques d'assemblages sont différentes et dépendent des coûts, facilité de manipulation des puces et plaques amincies, ainsi que de la précision d'alignement requise. Le circuit intégré 170 peut être reporté en « puce à plaque », c'est-à-dire un équipement d'assemblage reporte des circuits intégrés 170 dans chaque repère avant la découpe de la plaque hébergeant les cellules PV. A ce stade, le substrat des cellules PV est aminci et porté par une poignée temporaire. Il a été démontré la faisabilité de cet assemblage sur une épaisseur de la plaque amincie de l'ordre de 50 µm dans des maisons d'assemblages industrielles ou des centres de recherche et développement. Suite à cette étape, la plaque amincie est décollée de la poignée temporaire et reportés sur « tape » et attaché à un « frame » qui lui assure la rigidité nécessaire pour la manipulation suivante. Ensuite, les sous-systèmes cellules PV et circuit intégré 170 sont découpés et détachés du « tape ». Ensuite, une opération de « pick and place » permet de retourner les sous-systèmes cellules PV et circuits intégrés et d'assembler le circuit 480 sur la face opposée.

Différentes options concernant le premier mode de réalisation de l'invention, illustré par les figures 4a à 4j, sont décrites ci-après. D'une façon générale les options déjà décrites pour le premier mode de réalisation peuvent s'appliquer.
- Les options relatives au substrat sont identiques. Comme déjà décrit, on peut obtenir la structure SOI 100 par collage moléculaire de substrats « bulk ». L'option décrite dans les figures 2, où l'on remplace de plus la couche BOX 110 par une couche dopée 210 peut s'appliquer également. La structure finale obtenue (figure 4j) est modifiée en conséquence.
- Dans les étapes correspondant aux figures 4e et 4i, concernant les options relatives à la métallisation latérale, il est possible de ne pas réaliser les TSV et les lignes métalliques 150, 160 simultanément mais par étapes successives. En effet, dans l'exemple décrit en figure 4, les vias 410 et les interconnexions métalliques 150, 160 sont réalisés simultanément, mais cela n'est pas obligatoire. De même sur la figure 4i, les vias 460 et les interconnexions métalliques 470 sont réalisés simultanément sans que cela ne soit obligatoire. Cette modification ne change pas la structure obtenue qui est illustrée par la figure 4j.
- En ce qui concerne les options de réalisation des « TSV middle » 410, il est possible de réaliser ces TSV avant de structurer les îlots 130 de cellules PV. Pour ce faire, on utilise l'option où l'on obtient la structure SOI 100 par collage de substrats « bulk ». Dans ce cas, on part du substrat 105 et on y réalise la gravure des TSV avec le remplissage par l'isolant 411, la couche anti-diffusion et le métal du TSV. Ensuite une planarisation « mécanochimique », de type dit CMP, acronyme de l'anglais « chemical mecanical polishing » est effectuée. Opération qui est éventuellement suivie d'une planarisation chimique fine. On reporte ensuite par collage un substrat « bulk » de type P, oxydé. On réalise ainsi un collage moléculaire entre les deux oxydes. Puis on amincit le substrat reporté, comme décrit précédemment, pour ne laisser qu'une épaisseur de 10 à 160 µm de silicium de type P, et de préférence une épaisseur de 80 µm. On forme ensuite dans cette couche de silicium de type P les ilots. Les autres étapes du procédé qui s'appliquent sont décrites dans les figures 4. Naturellement, lors de l'étape 4e seules les métallisations latérales formant les zones d'accueil 160 et les connexions 150 entre cellules PV et TSC sont définies puisque les TSV middle sont déjà formés.

- Une autre manière de réaliser les « TSV middle » avant de structurer les îlots des cellules PV, consiste à partir de l'option substrat où l'on n'a pas de couche BOX 110 mais une couche dopée 210 comme décrit à la figure 2b. Dans ce cas, on part du substrat 105 où l'on a déjà créé une couche dopée N en surface sur une profondeur allant de 0,1 à 10 µm. On y réalise alors la gravure des TSV avec le remplissage par l'isolant, la couche anti-diffusion et le métal du TSV. Ensuite, comme ci-dessus, une planarisation de type CMP est effectuée qui est éventuellement suivie d'une planarisation chimique fine. Puis on réalise le report d'un substrat de type P qui est assemblé par collage moléculaire. Comme précédemment, le substrat reporté est ensuite aminci. On procède aussi à un dépôt d'isolant et à sa structuration par lithographie pour ouvrir des contacts vers les zones N et P des îlots comme décrit dans les figures 2. Naturellement, lors de l'étape 4e seules les métallisations latérales formant les zones d'accueil 160 et les connexions 150 entre cellules PV et TSC sont définies puisque les TSV middle sont déjà formés.
- En ce qui concerne les options relatives aux TSV réalisés à partir de la face arrière, c'est-à-dire les « TSV last », une option compatible avec toutes les options précédentes, c'est-à-dire celles relatives au substrat, à la métallisation et aux « TSV middle », consiste à ne pas remplir complètement ces TSV. On dispose alors une couche de métal conforme sur les flancs de gravure du TSV pour former un revêtement conducteur, par exemple en forme de chemise cylindrique, ce qui est généralement qualifié du terme anglais de « liner ».
- Une autre option de réalisation des « TSV last », qui est compatible seulement avec les options où l'on part de substrats « bulk », consiste à réaliser les « TSV middle » et les « TSV last » en même temps dans le substrat « bulk » de départ 105. Les TSV sont alors tous identiques et il n'est plus nécessaire, ni même possible, de les distinguer.
- On peut appliquer les options relatives au dopage P⁺, telles que décrites en référence à la figure 3 où l'on obtient une couche P⁺ continue 310. Les mêmes remarques et avantages concernant la structure obtenue s'appliquent aussi.

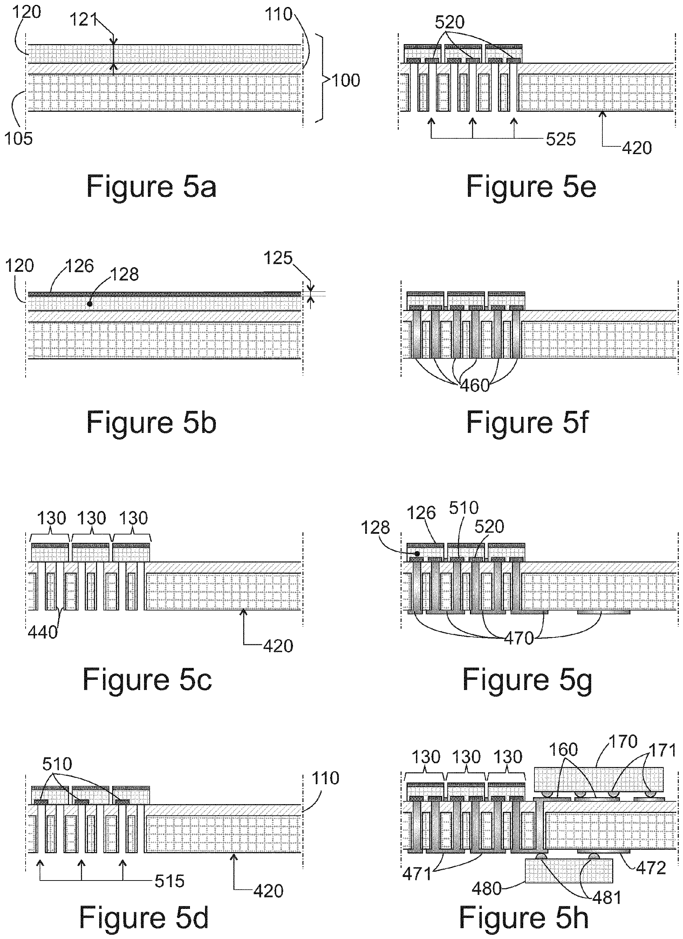

Les **figures 5a à 5h** décrivent un troisième mode de réalisation de l'invention dans lequel les ilots PV sont interconnectés à l'aide de TSV par la face arrière. L'avantage de ce mode de réalisation est notamment qu'il permet de connecter les cellules PV en face arrière ce qui élimine l'ombrage des cellules en face avant tel qu'il existe dans les autres modes de réalisation.

Comme montré sur la figure 5a le point de départ est le même que précédemment, c'est-à-dire un substrat 100 de type SOI avec une couche 120 de silicium dopé P d'une épaisseur 121 de 10 à 160 µm, et de préférence d'une épaisseur de 80 µm, sur une couche d'oxyde enterré (BOX) 110.

Puis, comme montré sur la figure 5b, on réalise une implantation pour doper, cette fois de type P⁺, depuis la surface, une couche d'épaisseur 125. Une activation, qui comme indiqué précédemment consiste à rendre électriquement actifs des dopants dans un semi-conducteur, peut être faite par laser ou « fast-annealing ». Le but de la couche conductrice P⁺ est d'empêcher les recombinaisons qui pourraient être dues aux imperfections de surface.

Comme illustré sur la figure 5c, une gravure profonde est ensuite réalisée à partir de la face avant pour séparer le silicium constituant la couche 120 en ilots isolés 130. Puis une gravure profonde est réalisée à partir de la face arrière 420 en vue de former des TSV. Les ouvertures ainsi formées s'étendent perpendiculairement au substrat. Elles sont formées sous les ilots 130 de sorte à parvenir sous la base d'un ilot 130 au niveau de la couche semi-conductrice 120. Chaque ilot 130 est associé à deux ouvertures.

Comme précédemment un isolant 130 est déposé puis gravé de manière anisotrope à l'aide d'une gravure dite « etch-back » qui ne laisse l'isolant que sur les flancs verticaux 440.

Ensuite, comme illustré sur la figure 5d, une implantation est réalisée par la face arrière sur une moitié 515 des ouvertures destinées à accueillir les TSV afin de doper, de type N⁺, les zones 510 de la couche 120 situées en regard de ces ouvertures. Chaque ilot 130 est ainsi associé à une ouverture se prolongeant par une implantation de type N⁺. Une activation peut être faite par laser ou « fast-annealing ». On crée ainsi les diodes PV, cette fois à l'interface avec la couche BOX 110.

Comme montré sur la figure 5e, une seconde implantation est réalisée de manière similaire, c'est-à-dire par la face arrière sur l'autre moitié 525 des ouvertures destinées à accueillir les TSV afin de doper, de type P⁺, les zones 520 de la couche 120 situées en regard de ces ouvertures pour obtenir un bon contact électrique. Chaque ilot 130 est ainsi associé à une ouverture se prolongeant par une implantation de type P⁺. Comme ci-dessus une activation peut être faite par laser ou « fast-annealing ». Ce dopage de type P+, bien qu'avantageux, n'est qu'optionnel. Les zones P+ sont dopées en premier (ou respectivement les zones N+) après gravure des ouvertures par la face arrière, uniquement au niveau des zones P+ (ou respectivement N+). Les ouvertures au niveau des zone N+ (ou respectivement P+) sont réalisées ensuite. Un dopage de type N+ (ou respectivement P+) est réalisé. Le niveau de dopage N+ (ou respectivement P+) est d'au moins un ordre de grandeur inférieur au dopage P+ (ou respectivement N+) de façon à ne pas être suffisant pour contredoper la zone N+ (ou respectivement P+) déjà réalisée.

Les figures 5f et 5g montrent, respectivement, le remplissage par la face arrière des vias traversants de type « TSV last » 460 et la formation de lignes métalliques 470 sur la face arrière. La structuration de ces dernières peut être faite comme précédemment par « lift-off ».

Les lignes métalliques 470 comprennent les connexions 471 servant à connecter électriquement les cellules PV entre elles. Plus précisément chaque connexion 471 relie électriquement un TSV connecté à une zone implantée N+ d'un premier ilot 130 à un autre TSV connecté à une zone implantée P+ d'un premier ilot 130 qui est de préférence adjacent au premier ilot 130.

Les lignes métalliques 470 comprennent également les zones d'accueil 472 pour connecter électriquement les cellules PV avec un circuit intégré externe 480 rapporté sur la face arrière du substrat 105.

Comme illustré sur la figure 5h, un ou plusieurs circuits intégrés externes, par exemple 170 et 480, peuvent être reportés, optionnellement, sur l'une ou l'autre ou sur les deux faces du substrat contenant les îlots photovoltaïques 130 à l'aide, par exemple, de la technique « flip-chip » comme représenté schématiquement, ou par toute autre technique de report et de connectique, telle que le « wire-bonding ».

Les options de réalisation décrites dans les modes précédents s'appliquent au troisième mode de réalisation de l'invention décrit dans les figures 5a à 5h. En particulier, la structure SOI de départ peut être réalisée à l'aide des options déjà décrites. Les « TSV last » peuvent être remplis complètement ou sous forme de « liner » comme déjà décrit également. Des TSV de type « TSV middle », à partir de la face avant, peuvent aussi être réalisés si nécessaire dans ce troisième mode de réalisation.

Une première option consiste à partir d'un substrat SOI.

Alternativement, il est possible de partir d'un substrat bulk oxydé comme expliqué précédemment. On reporte alors par collage moléculaire un substrat bulk de type P oxydé. On réalise ainsi un collage moléculaire entre les deux oxydes, puis on aminci le substrat reporté pour ne laisser de préférence que 10 à 160 µm de Si de type et de préférence 80 µm. Cette technique permet de reconstituer un substrat SOI équivalent à partir de deux substrats bulk.

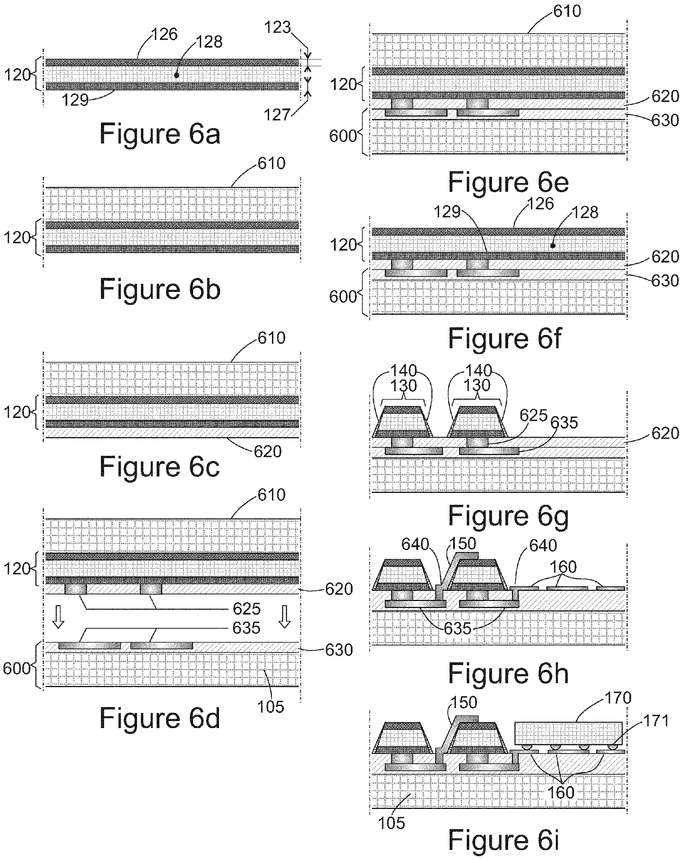

Les **figures 6a à 6i** décrivent un quatrième mode de réalisation de l'invention. Ce mode de réalisation est à particulièrement avantageux lorsque aucun autre élément relatif à l'architecture et packaging du système complet ne justifie l'utilisation de vias traversant le substrat de type « TSV ». Dans ce cas, le nombre d'étape du procédé silicium et de l'assemblage sont réduits, et la manipulation des puces est plus simple car il n'y a pas d'amincissement.

Comme montré sur la figure 6a on part d'un substrat 120 de type P d'une épaisseur allant de 10 à 160 µm et de préférence d'une épaisseur de 80 µm, dopé en face avant de type N⁺ 123 et en face arrière de type P⁺ 127. Le substrat est maintenu par une poignée en silicium (non illustrée) sur la face arrière 127. La portion dopée N+ est référencée 126, la portion dopée P est référencée 128 et la portion dopée P+ est référencée 129 en figure 6a. La portion P+ 129 sera utile plus loin pour réaliser un contact ohmique vers la couche P 128 et éviter un contact de type Schottky. La portion P+ créée un champ répulsif pour les électrons en face arrière.

Puis, comme montré sur la figure 6b on colle sur la face avant de ce substrat une poignée de manipulation de préférence en silicium 610. A ce stade, la poignée initialement présente sur la face arrière 127 est éliminée.

À l'étape suivante, illustrée par la figure 6c, on dépose une couche 620 d'un isolant, par exemple de l'oxyde de silicium (SiO2) sur la face arrière.

Comme montré sur la figure 6d on structure la couche 620 de SiO2 de la face arrière et on dépose du métal que l'on planarise par CMP pour obtenir des plages métalliques transversales 625. Ces plages métalliques transversales 625 traversent de part en part la couche isolante. Elles sont ainsi électriquement connectées à la couche dopée P+. On met la face arrière du substrat 120 en regard avec un substrat 600 ayant des plages métalliques latérales 635 isolées dans une couche 630 faite par exemple de SiO2. Ces plages métalliques latérales 635 s'étendent principalement selon un plan parallèle à celui de l'empilement 600. Ces plages métalliques latérales 635 s'étendent latéralement de manière à présenter au moins une première portion située au droit d'un ilot 130 et au moins une deuxième portion non située au droit de ce même ilot 130.

La figure 6e illustre l'assemblage des deux substrats 120, 600 qui sont rendus solidaires. Cette solidarisation s'effectue de préférence par un collage de leurs plages métalliques, 625 et 635, effectué à une température de l'ordre de 350°C. A cet effet, les plages métalliques transversales 625 sont situées au droit des plages métalliques 635 lorsque les deux substrats 120, 600 sont en regard.

La figure 6f illustre la structure obtenue après enlèvement de la poignée de manipulation 610. La poignée de manipulation est retirée par la technique dite « smart cut » (création d'une zone de fragilisation à l'interface entre la poignée et la couche dopée N+ par exemple par implantation d'ions puis rupture de la zone de fragilisation) en utilisant un polissage mécanochimique (CMP) et par meulage ou érosion mécanique, encore appelé « grinding », si nécessaire.

La figure 6g montre le résultat de la structuration par lithographie et gravure du substrat initial 120 pour y réaliser les îlots 130 de cellules PV. La gravure se fait avec arrêt sur la couche isolante 620. Comme précédemment, la gravure peut être « humide », par exemple à l'aide d'une solution de KOH, auquel cas la gravure se fait de façon isotrope et on obtient, comme représenté, des flancs inclinés. La gravure peut être aussi « sèche » auquel cas elle est anisotrope et on obtient des flancs perpendiculaires au plan du substrat. Un isolant est déposé sur toute la plaque puis gravé de manière anisotrope pour former des espaceurs 140 sur les flancs des îlots.

Comme montré sur la figure 6h une gravure de la couche 620 est réalisée pour former par la suite les connexions 150 effectués à partir de la face avant. Ces connexions 150 comprennent une partie 640 emplissant une cavité gravée dans la couche isolante 620 et parvenant à la plage métallique latérale 635. Typiquement, les cavités sont remplies de métal, par exemple du cuivre (Cu). La partie 640 s'étend verticalement au droit de ladite deuxième portion de plage métallique latérale 635, deuxième portion de plage métallique latérale 635 qui n'est pas située au droit de l'ilot 130.

Les connexions 150 comprennent également un tronçon connectant la zone N+ d'une cellule à la partie 640 de la connexion 150.

Au cours de cette séquence d'étapes, on réalise ainsi les lignes métalliques 150 servant à connecter électriquement les cellules PV entre elles. Plus précisément chaque connexion 150 relie électriquement une plage métallique latérale 635 connectée à la zone dopée P+ d'une cellule PV à la zone dopée N+ d'une autre cellule PV.

Au cours de cette séquence d'étapes, on réalise également les zones d'accueil 160 pour connecter électriquement les cellules PV avec un circuit intégré externe 170 rapporté sur la face avant de la couche 105, c'est-à-dire la face de l'empilement sur laquelle sont formés les ilots 130.

Avant remplissage des cavités par un métal tel que le cuivre des couches anti-diffusions peuvent être déposées. Le métal est gravé ou structuré de préférence par « lift-off ».

La figure 6i montre comment, comme précédemment, un circuit intégré externe 170 peut être reporté sur le substrat contenant les îlots photovoltaïques par exemple, comme représenté, par la technique « flipchip » ou par toute autre technique de report et de connectique, telle que le « wire-bonding ».

Les modes de réalisation décrits ci-dessus proposent des solutions faciles à mettre en oeuvre en fabriquant séparément le dispositif photovoltaïque et le circuit intégré puis en les assemblant mécaniquement et électriquement. La fabrication des cellules PV n'est donc pas contrainte par la fabrication du circuit intégré. Leurs performances peuvent donc être aisément améliorées et l'efficacité énergétique de l'alimentation du circuit intégré peut être augmentée.

L'invention n'est pas limitée aux modes de réalisations précédemment décrits et s'étend à tous les modes de réalisation couverts par les revendications.

Notamment, les modes de réalisation décrits en référence aux figures font apparaître des dispositifs comprenant chacun plusieurs cellules PV. L'invention s'étend également aux modes de réalisation dans lesquels le dispositif ne comprend qu'une seule cellule PV. Dans ce cas, le dispositif ne comporte pas de deuxièmes connexions mais uniquement des premières connexions.

## Revendications

1. Procédé de fabrication d'un dispositif photovoltaïque comprenant une cellule photovoltaïque ou une pluralité de cellules photovoltaïques (cellules PV) connectées à un circuit intégré électronique (170, 480), le procédé comprenant les étapes suivantes :
- une étape de réalisation d'un empilement comprenant la cellule ou la pluralité de cellules PV ce qui comprend pour la réalisation de chaque cellule PV la réalisation dans un matériau semi-conducteur d'au moins deux régions présentant des dopages P et N inverses ; dans lequel l'étape de réalisation de la cellule ou de la pluralité de cellules PV comprend l'étape suivante au moins, effectuée à partir de l'empilement comprenant un substrat (105) surmonté d'une couche isolante (110, 211, 620) et d'une couche semi-conductrice (120), la couche semi-conductrice (120) comprenant au moins une portion supérieure (126) s'étendant depuis une face supérieure de la couche semi-conductrice (120) et présentant un dopage P ou N et une portion inférieure (128) située sous la portion supérieure (126) et présentant un dopage P ou N inverse du dopage de la portion supérieure (126):
▪ une étape de formation de la cellule PV ou des cellules PV par gravure de la couche semi-conductrice (120) de manière à former respectivement un ou des ilots (130) séparés les uns des autres, comprenant chacun une superposition des portions inférieure (128) et supérieure (126) de la couche semi-conductrice (120) et présentant une face avant formée par la portion supérieure (126), chaque ilot (130) formant une cellule PV ;
- après l'étape de réalisation de la cellule ou la pluralité de cellules PV, un cycle d'étapes de connexion comprenant au moins la réalisation de premières connexions comportant au moins une zone d'accueil (160) destinées à relier électriquement la au moins une cellule PV avec au moins un circuit intégré électronique (170), ladite zone d'accueil étant située sur la couche isolante (110, 211, 620);
- après le cycle d'étapes de connexion, une étape de report, sur ledit empilement comprenant la cellule ou la pluralité de cellules PV, d'un circuit intégré électronique (170) préalablement fabriqué, l'étape de report étant effectuée de manière à connecter électriquement la au moins une zone d'accueil (160) avec une zone de contact électrique (171) portée par le circuit intégré électronique (170).

2. Procédé selon la revendication précédente dans lequel le dispositif photovoltaïque comprend une pluralité de cellules photovoltaïques (cellules PV) et ledit cycle d'étapes de connexion comprend la réalisation d'une pluralité de deuxièmes connexions (150, 471) électriques pour relier entre elles les cellules PV de ladite pluralité de cellules PV et dans lequel, de préférence, les étapes de formation des premières connexions et des deuxièmes connexions (150, 471) sont effectuées simultanément ou successivement.

3. Procédé selon l'une quelconque des revendications précédentes dans lequel après la gravure de la couche semi-conductrice (120) de manière à former le ou les ilots (130) et avant l'étape de réalisation du cycle d'étapes de connexion électriques, le procédé comprend une étape de formation d'espaceurs (140) uniquement sur les flancs de chaque îlot.

4. Procédé selon l'une quelconque des revendications précédentes dans lequel l'étape de formation des îlots (130) est effectuée de manière à isoler complètement les îlots (130) les uns par rapport aux autres.

5. Procédé selon l'une quelconque des revendications précédentes dans lequel l'étape de formation de chaque ilot (130) par gravure de la couche semi-conductrice (120) est effectuée de manière à conserver au pied de chaque ilot (130) une zone de contact (132) formée dans ladite portion inférieure (128) de la couche semi-conductrice (120) et qui n'est pas située au droit de ladite portion supérieure (126) et dans lequel, de préférence, on dope la zone de contact (132) de manière à la rendre électriquement conductrice et dans lequel, de préférence, le dispositif photovoltaïque comprend une pluralité de cellules PV, dans lequel ledit cycle d'étapes de connexion comprend la réalisation d'une pluralité de deuxièmes connexions (150, 471) électriques pour relier entre elles les cellules PV de ladite pluralité de cellules PV et dans lequel l'étape de réalisation d'une pluralité de deuxièmes connexions (150) électriques pour relier entre elles les cellules PV comprend la réalisation d'une connexion électrique connectant la zone de contact (132) d'une cellule PV à ladite face avant d'une autre cellule PV.

6. Procédé selon l'une quelconque des revendications 1 à 4 dans lequel l'étape de formation de chaque ilot (130) par gravure de la couche semi-conductrice (120) est effectuée de manière à stopper la gravure sur la couche isolante (110, 211, 620) en dehors du ou des ilots (130).

7. Procédé selon l'une quelconque des revendications 1 à 4 et 6 dans lequel le dispositif photovoltaïque comprend une pluralité de cellules PV, dans lequel ledit cycle d'étapes de connexion comprend la réalisation d'une pluralité de deuxièmes connexions (150, 471) électriques pour relier entre elles les cellules PV de ladite pluralité de cellules PV et dans lequel la réalisation d'une pluralité de deuxièmes connexions (150) électriques pour relier entre elles les cellules PV comprend les étapes suivantes :
- gravure, à partir d'une face de l'empilement comportant les cellules PV formées par les ilots (130), de toute l'épaisseur de la couche isolante (110, 211) et d'une partie de l'épaisseur du substrat (105) pour former une ouverture en dehors de chaque cellule PV;
- remplissage desdites ouvertures par un matériau conducteur et formation d'une connexion électrique (150) entre ledit matériau conducteur emplissant l'ouverture et ladite portion supérieure (126) de la couche semi-conductrice (120) de la cellule PV;
- amincissement de la face arrière (420) du substrat qui est opposée à la face du substrat au regard des cellules PV, jusqu'à faire déboucher sur ladite face arrière (420) les ouvertures emplies de métal qui forment alors des vias (410) traversants ;
- gravure, au droit des cellules PV, de toute l'épaisseur de la couche isolante (110, 211) et du substrat (105) pour former pour chaque cellule PV une ouverture additionnelle, chaque ouverture additionnelle s'étendant depuis la face arrière (420) du substrat (105) et atteignant la portion inférieure (128) de la couche semi-conductrice de chaque cellule PV;
- remplissage des ouvertures additionnelles par un matériau conducteur de manière à former des vias (460) connectant la face arrière du substrat (105) à chaque cellule PV ;
- dépôt sur la face arrière (420) du substrat (105) d'un matériau conducteur pour connecter électriquement au moins certains desdits vias (410) traversants connectés à la portion inférieure (128) d'une cellule PV à un via (460) connecté à la portion supérieure (126) d'une autre cellule PV.

8. Procédé selon l'une quelconque des revendications 1 à 4 et 6, dans lequel le dispositif photovoltaïque comprend une pluralité de cellules PV, dans lequel ledit cycle d'étapes de connexion comprend la réalisation d'une pluralité de deuxièmes connexions (150, 471) électriques pour relier entre elles les cellules PV de ladite pluralité de cellules PV et dans lequel la réalisation d'une pluralité de deuxièmes connexions (150) électriques pour relier entre elles les cellules PV comprend les étapes suivantes :
- gravure, au droit des cellules PV et à partir de la face arrière (420) du substrat (105), de toute l'épaisseur de la couche isolante (110, 211) et du substrat (105) pour former deux ouvertures pour chaque cellule PV, chaque ouverture s'étendant depuis la face arrière (420) et atteignant la portion inférieure (128) de la couche semi-conductrice de chaque cellule PV;
- dopage, pour chaque cellule PV, d'une zone de la portion inférieure (128) sur laquelle débouche l'une des deux ouvertures, ce dopage étant inverse de celui de la portion inférieure (128) ;
- remplissage pour chaque cellule PV des deux ouvertures par un matériau conducteur de manière à former des vias (460) connectant la face arrière du substrat (105) à chaque cellule PV;
- formation sur la face arrière (420) du substrat (105) de connexions électriques (471) de manière à connecter électriquement deux à deux des via associés à deux cellules PV et débouchant sur des zones de la portion inférieure (128) présentant des dopages inverses et dans lequel, de préférence, après la gravure des deux ouvertures pour chaque cellule PV et avant le remplissage pour chaque cellule PV des deux ouvertures par un matériau conducteur, on effectue une étape de dopage, pour chaque cellule PV, d'une zone de la portion inférieure (128) sur laquelle débouche l'autre des deux ouvertures, ce dopage étant inverse de celui de la portion inférieure (128) et présente un niveau de dopage au moins 10 fois et de préférence au moins 100 fois plus élevé que celui de la portion inférieure (128).

9. Procédé selon l'une quelconque des deux revendications précédentes dans lequel la réalisation des premières connexions comportant la zone d'accueil (160) pour un circuit intégré comprend additionellement la réalisation d'au moins une deuxième zone d'accueil (472) située sur la face arrière (420) du substrat (105).

10. Procédé selon l'une quelconque des trois revendications précédentes dans lequel la réalisation des premières connexions comportant la zone d'accueil (160) pour un circuit intégré comprend la réalisation :
- de la zone d'accueil (160) située sur la couche isolante (210, 211) pour recevoir un premier circuit intégré (170) sur la face de la couche isolante (120, 211) tournée au regard de la ou des cellules PV ;
- d'au moins une deuxième zone d'accueil (472) située sur la face arrière (420) du substrat (105) pour recevoir un deuxième circuit intégré (481) sur ladite face arrière (420).

11. Procédé selon l'une quelconque des revendications précédentes dans lequel l'empilement comprenant un substrat (105) surmonté d'une couche isolante (110) et d'une couche semi-conductrice (120) est un substrat de type silicium sur isolant (SOI) dans lequel la couche isolante (110) est formée d'un oxyde de silicium et dans lequel on effectue, à partir du substrat SOI, une étape de dopage de la face supérieure de la couche semi-conductrice (120) de manière à ce que la couche semi-conductrice (120) comprenne ladite portion supérieure (126) qui présente un dopage inverse de celui de ladite portion inférieure (128) formée par le reste de la couche semi-conductrice (120).

12. Procédé selon l'une quelconque des revendications précédentes dans lequel l'empilement comprenant un substrat (105) surmonté d'une couche isolante (211) est obtenu en effectuant les étapes suivantes à partir d'un substrat massif (105) en un matériau semi-conducteur:
- dopage de type N ou P d'une partie supérieure du substrat massif (105) pour former la couche isolante (211) dudit empilement;
- report sur la partie supérieure (211) d'une couche semi-conductrice (120) présentant un dopage inverse de celui de la partie supérieure (211) du substrat massif (105) ;
- amincissement de ladite couche semi-conductrice (120) reportée ;
- dopage de la face supérieure de ladite couche semi-conductrice (120) reportée de manière à ce que cette couche semi-conductrice (120) reportée présente une portion supérieure (126) qui s'étend depuis sa face supérieure et qui présente un dopage inverse d'une portion inférieure (128) formée par le reste de ladite couche semi-conductrice (120) reportée.

13. Procédé selon l'une quelconque des deux revendications précédentes dans lequel ladite portion inférieure (128) est formée d'une première portion d'épaisseur présentant un dopage P ou N et d'une autre portion d'épaisseur également dopée P respectivement N mais dont le niveau de dopage est au moins 100 fois supérieur à celui de la première portion et est au moins égal à 1 atome de l'espèce dopante pour moins de 1000 atomes du matériau formant la couche semi-conductrice (dopage P+ respectivement N+), ladite autre portion étant située entre la couche isolante (110, 211) et ladite première portion d'épaisseur dopée P respectivement N et dans lequel ladite autre portion d'épaisseur est au contact de la couche isolante et de ladite première portion d'épaisseur.

14. Procédé selon l'une quelconque des revendications 1 à 4 et 6 dans lequel le dispositif photovoltaïque comprend une pluralité de cellules PV, dans lequel ledit cycle d'étapes de connexion comprend la réalisation d'une pluralité de deuxièmes connexions (150, 471) électriques pour relier entre elles les cellules PV de ladite pluralité de cellules PV et dans lequel préalablement à l'étape de formation des ilots (130) par gravure de la couche semi-conductrice (120) pour former les cellules PV on dispose sous la couche semi-conductrice (120) une couche isolante (620) et on forme à l'intérieur de la couche isolante (620) et pour chaque cellule PV une plage conductrice (625, 635), connectée à la portion inférieure (128) de la couche semi-conductrice (120) de la cellule PV et s'étendant latéralement de manière à présenter au moins une première portion située au droit de la cellule PV et au moins une deuxième portion non située au droit de cette même cellule PV;
et dans lequel, la réalisation d'une pluralité de deuxièmes connexions (150) électriques pour relier entre elles les cellules PV comprend les étapes suivantes :
- ouverture de la couche isolante (620) au droit de la deuxième portion de la plage métallique (625, 635) de la cellule PV, dépôt d'un matériau conducteur dans l'ouverture et sur une partie du flanc d'une autre cellule PV jusqu'à atteindre la portion supérieure (126) de cette autre cellule PV, de manière à réaliser une connexion électrique entre la portion inférieure (128) et la portion supérieure (126) de deux cellules PV.

15. Procédé selon l'une quelconque des revendications précédentes dans lequel le circuit intégré électronique (170, 480) comprend des transistors notamment des transistors complémentaires (C) de type métal-oxyde-semi-conducteur (MOS) et/ou des mémoires et/ou des batteries et/ou des dispositifs passifs tels que des capacités ou des inductances.

16. Dispositif photovoltaïque comprenant une ou plusieurs cellules photovoltaïques (cellules PV) et au moins un circuit intégré électronique (170) connecté à la cellule PV ou à la pluralité de cellules PV, le dispositif comprenant:
un substrat (105) surmonté d'une couche isolante (110, 211, 620) et une couche semi-conductrice (120) disposée sur une face avant de la couche isolante (110, 211, 620), la cellule PV ou la pluralité de cellules PV étant formée dans ladite couche semi-conductrice (120);
- **caractérisé en ce que** ladite face avant de la couche isolante (110, 211, 620, 630) porte des connexions électriques formant au moins une zone d'accueil (160) configurée pour connecter au moins une cellule PV avec au moins un circuit intégré électronique (170);
- et **en ce que** ledit au moins un circuit intégré électronique (170) est disposé au contact de et sur l'au moins une zone d'accueil (160) au regard de la face avant de la couche isolante (110, 211, 620) ;
- l'au moins une zone d'accueil (160) permet de connecter à elle seule au moins une cellule PV avec l'au moins un circuit intégré électronique (170).

17. Dispositif photovoltaïque selon la revendication précédente dans lequel le dispositif photovoltaïque comprend une pluralité de cellules photovoltaïques (cellules PV) et dans lequel ladite face avant de la couche isolante (110, 211, 620, 630) porte des connexions (150) électriques pour relier entre elles les cellules PV de ladite pluralité de cellules PV.

18. Dispositif photovoltaïque selon l'une quelconque des deux revendications précédentes comprenant un circuit intégré électronique (480) additionnel disposé au regard d'une face arrière (420) du substrat (105), connecté à la ou à ladite pluralité de cellules PV de manière à ce que ladite couche isolante (110, 211) soit disposée entre deux circuits intégrés électroniques (170, 480).

## Patentansprüche

1. Verfahren zum Herstellen einer Photovoltaik-Vorrichtung mit einer Photovoltaik-Zelle bzw. einer Mehrzahl von Photovoltaik-Zellen (PV-Zellen), die mit einer integrierten Schaltung (170, 480) verbunden sind, wobei das Verfahren die nachfolgenden Schritte umfasst:
- einen Schritt des Ausbildens einer die PV-Zelle bzw. die Mehrzahl von PV-Zellen enthaltenden Stapelung, was für das Ausbilden einer jeden PV-Zelle das Ausbilden von zumindest zwei Bereichen aus einem Halbleitermaterial umfasst, die umgekehrte p- und n-Dotierungen aufweisen; wobei der Schritt des Ausbildens der PV-Zelle bzw. der Mehrzahl von PV-Zellen zumindest den nachfolgenden Schritt umfasst, der ausgehend von der Stapelung erfolgt, die ein von einer Isolierschicht (110, 211, 620) und einer Halbleiterschicht (120) überragtes Substrat (105) enthält, wobei die Halbleiterschicht (120) zumindest einen oberen Abschnitt (126), der sich von einer Oberseite der Halbleiterschicht (120) ausgehend erstreckt und eine p- bzw. n-Dotierung aufweist, und einen unteren Abschnitt (128) enthält, der unter dem oberen Abschnitt (126) liegt und eine zur Dotierung des oberen Abschnitts (126) umgekehrte p- bzw. n-Dotierung aufweist:
- einen Schritt des Ausbildens der PV-Zelle bzw. der PV-Zellen durch Ätzen der Halbleiterschicht (120) derart, dass eine Insel bzw. Inseln (130) gebildet wird/werden, die voneinander getrennt sind, jeweils eine Übereinangerlagerung des unteren Abschnitts (128) und des oberen Abschnitts (126) der Halbleiterschicht (120) enthalten und eine Vorderseite aufweisen, die aus dem oberen Abschnitt (126) gebildet ist, wobei jede Insel (130) eine PV-Zelle bildet;
- nach dem Schritt des Ausbildens der PV-Zelle bzw. der Mehrzahl von PV-Zellen einen Zyklus von Verbindungsschritten, umfassend zumindest das Ausbilden von ersten Verbindungen mit zumindest einem Aufnahmebereich (160), die dazu bestimmt sind, die zumindest eine PV-Zelle mit zumindest einer integrierten Schaltung (170) zu verbinden, wobei der Aufnahmebereich an der Isolierschicht (110, 211, 620) liegt;
- nach dem Zyklus von Verbindungsschritten einen Übertragungsschritt zum Übertragen einer zuvor hergestellten integrierten Schaltung (170) auf die Stapelung mit der PV-Zelle bzw. der Mehrzahl von PV-Zellen, wobei der Übertragungsschritt so durchgeführt wird, dass der zumindest eine Aufnahmebereich (160) mit einem elektrischen Kontaktbereich (171) verbunden wird, der von der integrierten Schaltung (170) getragen wird.

2. Verfahren nach dem vorangehenden Anspruch, wobei die Photovoltaik-Vorrichtung eine Mehrzahl von Photovoltaik-Zellen (PV-Zellen) enthält und der Zyklus von Verbindungsschritten das Ausführen einer Mehrzahl von zweiten elektrischen Verbindungen (150, 471) umfasst, um die PV-Zellen der Mehrzahl von PV-Zellen miteinander zu verbinden und wobei vorzugsweise die Schritte des Ausbildens der ersten Verbindungen und der zweiten Verbindungen (150, 471) gleichzeitig oder nacheinander erfolgen.

3. Verfahren nach einem der vorangehenden Ansprüche, wobei nach dem Ätzen der Halbleiterschicht (120) zum Ausbilden der Insel bzw. der Inseln (130) und vor dem Schritt des Ausbildens des Zyklus von elektrischen Verbindungsschritten das Verfahren einen Schritt des Ausbildens von Abstandshaltern (140) nur an den Flanken einer jeden Insel umfasst.

4. Verfahren nach einem der vorangehenden Ansprüche, wobei der Schritt des Ausbildens der Inseln (130) so erfolgt, das die Inseln (130) vollständig voneinander isoliert sind.

5. Verfahren nach einem der vorangehenden Ansprüche, wobei der Schritt des Ausbildens jeder Insel (130) durch Ätzen der Halbleiterschicht (120) so erfolgt, dass am Fuße einer jeden Insel (130) ein Kontaktbereich (132) erhalten bleibt, der in dem unteren Abschnitt (128) der Halbleiterschicht (120) ausgebildet ist und der nicht im Bereich des oberen Abschnitts (126) liegt, wobei vorzugsweise der Kontaktbereich (132) so dotiert wird, dass er elektrisch leitend gemacht wird, und wobei vorzugsweise die Photovoltaik-Vorrichtung eine Mehrzahl von PV-Zellen enthält, wobei der Zyklus von Verbindungsschritten das Ausbilden einer Mehrzahl von zweiten elektrischen Verbindungen (150, 471) umfasst, um die PV-Zellen der Mehrzahl von PV-Zellen miteinander zu verbinden, und wobei der Schritt des Ausbildens einer Mehrzahl von zweiten elektrischen Verbindungen (150) zum Verbinden der PV-Zellen miteinander das Ausbilden einer elektrischen Verbindung umfasst, welche den Kontaktbereich (132) einer PV-Zelle mit der Vorderseite einer weiteren PV-Zelle verbindet.

6. Verfahren nach einem der Ansprüche 1 bis 4, wobei der Schritt des Ausbildens einer jeden Insel (130) durch Ätzen der Halbleiterschicht (120) so erfolgt, dass das Ätzen an der Isolierschicht (110, 211, 620) außerhalb der Insel bzw. Inseln (130) unterbrochen wird.

7. Verfahren nach einem der Ansprüche 1 bis 4 und 6, wobei die Photovoltaik-Vorrichtung eine Mehrzahl von Photovoltaik-Zellen enthält, wobei der Zyklus von Verbindungsschritten das Ausführen einer Mehrzahl von zweiten elektrischen Verbindungen (150, 471) umfasst, um die PV-Zellen der Mehrzahl von PV-Zellen miteinander zu verbinden, und wobei das Ausbilden einer Mehrzahl von zweiten elektrischen Verbindungen (150) zum Verbinden der PV-Zellen miteinander die nachfolgenden Schritte umfasst:
- Ätzen der gesamten Dicke der Isolierschicht (110, 211) und eines Teils der Dicke des Substrats (105) ausgehend von einer Seite der Stapelung mit den aus den Inseln (130) gebildeten PV-Zellen, um eine Öffnung außerhalb einer jeden PV-Zelle zu bilden;
- Füllen der Öffnungen mit einem leitfähigen Material und Ausbilden einer elektrischen Verbindung (150) zwischen dem die Öffnung ausfüllenden leitfähigen Material und dem oberen Abschnitt (126) der Halbleiterschicht (120) der PV-Zelle;
- Verdünnen der Rückseite (420) des Substrats, die der Seite des Substrat entgegengesetzt ist, die den PV-Zellen gegenüberliegt, bis auf der Rückseite (420) die mit Metall gefüllten Öffnungen durchstoßen werden, die dann durchgehende Durchführungen (410) bilden;
- Ätzen der gesamten Dicke der Isolierschicht (110, 211) und des Substrats (105) im Bereich der PV-Zellen, um für jede PV-Zelle eine zusätzliche Öffnung zu bilden, wobei jede zusätzliche Öffnung sich von der Rückseite (420) des Substrats (105) ausgehend erstreckt und den untern Abschnitt (128) der Halbleiterschicht einer jeden PV-Zelle erreicht;
- Füllen der zusätzlichen Öffnungen mit einem Leitermaterial, so dass Durchführungen (460) gebildet werden, welche die Rückseite des Substrats (105) jeder PV-Zelle verbinden;
- Aufbringen eines leitfähigen Materials auf die Rückseite (420) des Substrats (105), um zumindest bestimmte der durchgehenden Durchführungen (410), die mit dem unteren Abschnitt (128) einer PV-Zelle verbunden sind, elektrisch mit einer Durchführung (460) zu verbinden, die mit dem oberen Abschnitt (126) einer weiteren PV-Zelle verbunden ist.

8. Verfahren nach einem der Ansprüche 1 bis 4 und 6, wobei die Photovoltaik-Vorrichtung eine Mehrzahl von PV-Zellen enthält, wobei der Zyklus von Verbindungsschritten das Ausführen einer Mehrzahl von zweiten elektrischen Verbindungen (150, 471) umfasst, um die PV-Zellen der Mehrzahl von PV-Zellen miteinander zu verbinden, und wobei das Ausbilden einer Mehrzahl von zweiten elektrischen Verbindungen (150) zum Verbinden der PV-Zellen miteinander die nachfolgenden Schritte umfasst:
- Ätzen der gesamten Dicke der Isolierschicht (110, 211) und des Substrats (105) im Bereich der PV-Zellen und ausgehend von der Rückseite (420) des Substrats (105), um zwei Öffnungen für jede PV-Zelle zu bilden, wobei sich jede Öffnung von der Rückseite (420) ausgehend erstreckt und den unteren Abschnitt (128) der Halbleiterschicht einer jeden PV-Zelle erreicht;
- für jede PV-Zelle Dotieren eines Bereichs des unteren Abschnitts (128), bei dem eine der beiden Öffnungen ausmündet, wobei diese Dotierung umgekehrt zu der des unteren Abschnitts (128) erfolgt;
- für jede PV-Zelle Füllen der beiden Öffnungen mit einem leitfähigen Material derart, dass Durchführungen (460) gebildet werden, die die Rückseite des Substrats (105) mit jeder PV-Zelle verbinden;
- Ausbilden von elektrischen Verbindungen (471) auf der Rückseite (420) des Substrats (105), so dass Durchführungen paarweise elektrisch verbunden werden, die zwei PV-Zellen zugeordnet sind und an Bereichen des unteren Abschnitts (128) ausmünden, die umgekehrte Dotierungen aufweisen,
und wobei vorzugsweise nach dem Ätzen der beiden Öffnungen für jede PV-Zelle und vor dem Füllen der beiden Öffnungen mit einem leitfähigen Material für jede PV-Zelle ein Schritt des Dotierens von einem Bereich des unteren Abschnitts (128) für jede PV-Zelle erfolgt, an den die andere der beiden Öffnungen ausmündet, wobei diese Dotierung umgekehrt zu der des unteren Abschnitts (128) ist und zumindest einen Dotierungspegel aufweist, der zumindest 10 mal und vorzugsweise zumindest 100 mal höher als der des unteren Abschnitts (128) ist.

9. Verfahren nach einem der beiden vorangehenden Ansprüche, wobei das Ausbilden der ersten Verbindungen, die den Aufnahmebereich (160) für eine integrierte Schaltung aufweisen, zusätzlich das Ausbilden zumindest eines zweiten Aufnahmebereichs (472) umfasst, der auf der Rückseite (420) des Substrats (105) liegt.

10. Verfahren nach einem der drei vorangehenden Ansprüche, wobei das Ausbilden der ersten Verbindungen, die den Aufnahmebereich (160) für eine integrierte Schaltung aufweisen, das Ausbilden von
- einem Aufnahmebereich (160) umfasst, der auf der Isolierschicht (210, 211) liegt, um eine erste integrierte Schaltung (170) auf der Seite der Isolierschicht (120, 211) aufzunehmen, die der bzw. den PV-Zellen gegenüberliegt, sowie
- von zumindest einem zweiten Aufnahmebereich (472), der auf der Rückseite (420) des Substrats (105) liegt, um eine zweite integrierte Schaltung (481) auf der Rückseite (420) aufzunehmen.

11. Verfahren nach einem der vorangehenden Ansprüche, wobei die Stapelung, die ein Substrat (105) enthält, das von einer Isolierschicht und einer Halbleiterschicht (120) überragt wird, ein Substrat vom Typ Silizium-auf-Isolator (SOI) ist, wobei die Isolierschicht (110) aus einem Siliziumoxid gebildet ist und wobei ausgehend von dem SOI-Substrat ein Schritt des Dotierens der Oberseite der Halbleiterschicht (120) so erfolgt, dass die Halbleiterschicht (120) den oberen Abschnitt (126) enthält, der eine umgekehrte Dotierung zu der des unteren Abschnitts (128) aufweist, der aus der restlichen Halbleiterschicht (120) gebildet ist.

12. Verfahren nach einem der vorangehenden Ansprüche, wobei die Stapelung, die ein Substrat (105) enthält, das von einer Isolierschicht (211) überragt wird, dadurch erhalten wird, dass die nachfolgenden Schritte ausgehend von einem massiven Substrat (105) aus einem Halbleitermaterial durchgeführt werden:
- n- bzw. p-Dotieren eines oberen Bereiches des massiven Substrats (105), um die Isolierschicht (211) der Stapelung auszubilden;
- Übertragen einer Halbleiterschicht (120), die eine umgekehrte Dotierung zu der des oberen Bereichs (211) des massiven Substrats (105) aufweist, auf den oberen Bereich (211);
- Verdünnen der übertragenen Halbleiterschicht (120);
- Dotieren der Oberseite der übertragenen Halbleiterschicht (120) so, dass diese übertragene Halbleiterschicht (120) einen oberen Abschnitt (126) aufweist, der sich von ihrer Oberseite ausgehend erstreckt und eine umgekehrte Dotierung zu der eines unteren Abschnitts (128) aufweist, der aus der restlichen übertragenen Halbleiterschicht (120) gebildet ist.

13. Verfahren nach einem der beiden vorangehenden Ansprüche, wobei der untere Abschnitt (128) aus einem Dickenabschnitt mit einer p- bzw. n-Dotierung und einem weiteren Dickenabschnitt gebildet ist, der auch p- bzw. n-dotiert ist, jedoch dessen Dotierungspegel zumindest 100 mal höher als der des ersten Abschnitts ist und zumindest gleich 1 Atom des dotierenden Stoffs bei zumindest 1000 Atomen des die Halbleiterschicht bildenden Materials ist (p+ bzw. n+ Dotierung), wobei der weitere Abschnitt zwischen der Isolierschicht (110, 211) und dem p- bzw. n-dotierten ersten Dickenabschnitt liegt und wobei der weitere Dickenabschnitt mit der Isolierschicht und dem ersten Dickenabschnitt in Kontakt ist.

14. Verfahren nach einem der Ansprüche 1 bis 4 und 6, wobei die Photovoltaik-Vorrichtung eine Mehrzahl von PV-Zellen enthält, wobei der Zyklus von Verbindungsschritten das Ausbilden einer Mehrzahl von zweiten elektrischen Verbindungen (150, 471) umfasst, um die PV-Zellen der Mehrzahl von PV-Zellen miteinander zu verbinden, und wobei vor dem Schritt des Ausbildens von Inseln (130) durch Ätzen der Halbleiterschicht (120) zum Ausbilden der PV-Zellen unter der Halbleiterabschnitt (120) eine Isolierschicht (620) angeordnet wird und innerhalb der Isolierschicht (620) und für jede PV-Zelle ein Leiterbereich (625, 635) ausgebildet wird, der mit dem unteren Abschnitt (128) der Halbleiterschicht (120) der PV-Zelle verbunden ist und sich seitlich so erstreckt, dass er zumindest einen ersten Abschnitt, der im Bereich der PV-Zelle liegt, und zumindest einen zweiten Abschnitt, der nicht im Bereich dieser gleichen PV-Zelle liegt, aufweist;
und wobei das Ausbilden einer Mehrzahl von zweiten elektrischen Verbindungen (150) zum Verbinden der PV-Zellen miteinander die nachfolgenden Schritte umfasst:
- Öffnen der Isolierschicht (620) im Bereich des zweiten Abschnitts des Metallbereichs (625, 635) der PV-Zelle, Aufbringen eines Leitermaterials in die Öffnung und auf einen Teil der Flanke einer weiteren PV-Zelle, bis der obere Abschnitt (126) dieser weiteren PV-Zelle erreicht ist, so dass eine elektrische Verbindung zwischen dem unteren Abschnitt (128) und dem oberen Abschnitt (126) der beiden PV-Zellen hergestellt wird.

15. Verfahren nach einem der vorangehenden Ansprüche, wobei die integrierte Schaltung (170, 480) Transistoren, insbesondere komplementäre Transistoren (C) vom Typ Metall-Oxid-Halbleiter (MOS) und/oder Speicher und/oder Batterien und/oder passive Vorrichtungen, wie Kapazitäten oder Induktivitäten, aufweist.

16. Photovoltaik-Vorrichtung mit zumindest einer bzw. mehreren Photovoltaik-Zellen (PV-Zellen) und zumindest einer integrierten Schaltung (170), die mit der PV-Zelle bzw. der Mehrzahl von PV-Zellen verbunden ist, wobei die Vorrichtung enthält:
ein Substrat (105), das von einer Isolierschicht (110, 211, 620) und einer Halbleiterschicht (120) überragt wird, die auf einer Vorderseite der Isolierschicht (10, 211, 620) angeordnet ist, wobei die PV-Zelle bzw. die Mehrzahl von PV-Zellen aus der Halbleiterschicht (120) ausgebildet ist;
- **dadurch gekennzeichnet, dass** die Vorderseite der Isolierschicht (110, 212, 620, 630) elektrische Verbindungen trägt, die zumindest einen Aufnahmebereich (160) bilden, der dazu ausgebildet ist, zumindest eine PV-Zelle mit zumindest einer integrierten Schaltung (170) zu verbinden;
- und dadurch, dass zumindest eine integrierte Schaltung (170) im Kontakt mit und an dem zumindest einen Aufnahmebereich (160) gegenüber der Vorderseite der Isolierschicht (110, 211, 620) angeordnet ist;
- der zumindest eine Aufnahmebereich (160) gestattet, allein zumindest eine PV-Zelle mit der zumindest einen integrierten Schaltung (170) zu verbinden.

17. Photovoltaik-Vorrichtung nach dem vorangehenden Anspruch, wobei die Photovoltaik-Vorrichtung eine Mehrzahl von Photovoltaik-Zellen (PV-Zellen) enthält und wobei die Vorderseite der Isolierschicht (110, 211, 620, 630) elektrische Verbindungen (150) trägt, um die PV-Zellen der Mehrzahl von PV-Zellen miteinander zu verbinden.

18. Photovoltaik-Vorrichtung nach einem der beiden vorangehenden Ansprüche, enthaltend eine zusätzliche integrierte Schaltung (480), die gegenüber einer Rückseite (420) des Substrats (105) angeordnet ist und mit der PV-Zelle bzw. der Mehrzahl von PV-Zellen so verbunden ist, dass die Isolierschicht (110, 211) zwischen zwei integrierten Schaltungen (170, 480) angeordnet ist.

## Claims

1. A method for manufacturing a photovoltaic device comprising a photovoltaic cell or a plurality of photovoltaic cells (PV cells) connected to an electronic integrated circuit (170, 480), the method comprising the following steps:
- a step of executing a stack comprising the cell or the plurality of PV cells which comprises for the executing , of each PV cell the execution in a semi-conducting material of at least two regions having opposite P and N doping; wherein the step of executing the cell or the plurality of PV cells comprises the following step at least, executed from the stack comprising a substrate (105) topped with an insulating layer (110, 211, 620) and a semi-conducting layer (120), the semi-conducting layer (120) comprising at least one upper portion (126) extending from an upper face of the semi-conducting layer (120) and having a P or N doping and a lower portion (128) located under the upper portion (126) and having a P or N doping opposite to the doping of the upper portion (126):
- a step of forming the PV cell or PV cells by etching the semi-conducting layer (120) so as to form respectively one or more island(s) (130) distant from each other, each one comprising a superimposition of the lower (128) and upper portions (126) of the semi-conducting layer (120) and having a front face formed by the upper portion (126), each island (130) forming a PV cell;
- after the step of executing the cell or the plurality of PV cells, a cycle of steps of connection comprising at least executing the first connections comprising at least one receiving area (160) intended to electrically connect the at least one PV cell with at least one electronic integrated circuit (170), said receiving area being located on the insulating layer (110, 211, 620);
- after the cycle of the steps of connection, a step of transferring, onto said stack comprising the cell or the plurality of PV cells, a previously manufactured electronic integrated circuit (170), with the step of transfer being executed so as to electrically connect the at least one receiving area (160) with an electrical contact area (171) carried by the electronic integrated circuit (170).

2. A method according to the preceding claim, wherein the photovoltaic device comprises a plurality of photovoltaic cells (PV cells) and said cycle of steps of connection comprises the execution of a plurality of second electric connections (150, 471) to interconnect the PV cells of said plurality of PV cells and wherein, preferably, the steps of forming the first connections and the second connections (150, 471) are executed simultaneously or successively.

3. A method according to any of the preceding claims, wherein after the etching of the semi-conducting layer (120) so as to form the island(s) (130) and prior to the step of executing the cycle of the steps of electric connections, the method comprises a step of forming spacers (140) on the sides of each island only.

4. A method according to any of the preceding claims, wherein the step of forming islands (130) is executed so as to fully insulate the islands (130) from one another.

5. A method according to any of the preceding claims, wherein the step of forming each island (130) by etching the semi-conducting layer (120) is executed so as to preserve, at the root of each island (130) a contact area (132) formed in said lower portion (128) of the semi-conducting layer (120) and which is not located under said upper portion (126) and wherein, preferably, the contact area (132) is doped so as to make it electrically conducting and wherein, preferably the photovoltaic device comprises a plurality of PV cells, wherein said cycle of steps of connection comprises the execution of a plurality of second electric connections (150, 471) to interconnect the PV cells of said plurality of PV cells and wherein the step of execution of a plurality of second electric connections (150) to interconnect the PV cells comprises the execution of an electric connection connecting the contact area (132) of a PV cell to said front face of another PV cell.

6. A method according to any of claims 1 to 4, wherein the step of forming each island (130) by etching the semi-conducting layer (120) is executed so as to stop the etching on the insulating layer (110, 211, 620) out of the island(s) (130).

7. A method according to any of claims 1 to 4 and 6, wherein the photovoltaic device comprises a plurality of PV cells, wherein said cycle of steps of connection comprises the execution of a plurality of second electric connections (150, 471) to interconnect the PV cells of said plurality of PV cells and wherein the execution of a plurality of second electric connections (150) to interconnect the PV cells comprises the following steps:
- etching, from a face of the stack comprising the PV cells formed by the islands (130), the whole thickness of the insulating layer (110, 211) and a part of the thickness of the substrate (105) to form an opening out of each PV cell;
- filling said openings with a conducting material and forming an electric connection (150) between said conducting material filling the opening and said upper portion (126) of the semi-conducting layer (120) of the PV cell;
- thinning the rear face (420) of the substrate opposite the face of the substrate facing the PV cells, in order to lead until the openings, on said rear face (420), the openings filled with metal which then form through vias (410);
- etching, under the PV cells, the whole thickness of the insulating layer (110, 211) and the substrate (105) to form, for each PV cell, an additional opening, with each additional opening extending from the rear face (420) of the substrate (105) and reaching the lower portion (128) of the semi-conducting layer of each PV cell;
- filling the additional openings with a conducting material so as to form vias (460) connecting the rear face of the substrate (105) to each PV cell;
- depositing, on the rear face (420) of the substrate (105), a conducting material to electrically connect at least some of said through vias (410) connected to the lower portion (128) of a PV cell to a via (460) connected to the upper portion (126) of another PV cell.

8. A method according to any of claims 1 to 4 and 6, wherein the photovoltaic device comprises a plurality of PV cells, wherein said cycle of steps of connection comprises the execution of a plurality of second electric connections (150, 471) to interconnect the PV cells of said plurality of PV cells and wherein the execution of a plurality of second electric connections (150) to interconnect the PV cells comprises the following steps:
- etching, under PV cells and from the rear face (420) of the substrate (105), the whole thickness of the insulating layer (110, 211) and the substrate (105) to form two openings for each PV cell, with each opening extending from the rear face (420) and reaching the lower portion (128) of the semi-conducting layer of each PV cell;
- doping, for each PV cell, an area of the lower portion (128) whereto one of the two openings leads, with such doping being opposite that of the lower portion (128);
- filling, for each PV cell, the two openings with a conducting material so as to form vias (460) connecting the rear face of the substrate (105) of each PV cell;
- forming, on the rear face (420) of the substrate (105), electric connections (471) so as to electrically connect two by two vias associated with two PV cells and leading to areas of the lower portion (128) having opposite dopings and wherein, preferably, after etching the two openings for each PV cell and prior to filling, for each PV cell, the two openings with a conducting material, a step of doping is executed, for each PV cell, of an area of the lower portion (128 whereto the other one of said two openings leads, such doping being opposite that of the lower portion (128) and has a level of doping at least 10 times and preferably at least 100 times greater than that of the lower portion (128).

9. A method according to any of the two preceding claims, wherein the execution of the first connections comprising the receiving area (160) for an integrated circuit further comprises the execution of at least one second receiving area (472) located on the rear face (420) of the substrate (105).

10. A method according to any of the three preceding claims, wherein the execution of the first connections comprising the receiving area (160) for an integrated circuit comprises the execution:
- of the receiving area (160) located on the insulating layer (210, 211) to receive a first integrated circuit (170) on the face of the insulating layer (120, 211) turned in front of the PV cell(s);
- of at least one second receiving area (472) located on the rear face (420) of the substrate (105) to receive a second integrated circuit (481) on said rear face (420).

11. A method according to any of the preceding claims, wherein the wherein the stack comprising a substrate (105) topped with an insulating layer (110) and a semi-conducting layer (120) is a substrate of the silicon on insulator (SOI) type wherein the insulating layer (110) is made of a silicon oxide and wherein a step of doping the upper face of the semi-conducting layer (120) is executed from the SOI substrate, so that the semi-conducting layer (120) comprises said upper portion (126) having a doping opposite that of said lower portion (128) formed by the rest of the semi-conducting layer (120).

12. A method according to any of the preceding claims, wherein the stack comprising a substrate (105) topped with an insulating layer (211) is obtained by executing the following steps from a massive substrate (105) made of a semi-conducting material:
- N or P type doping of an upper part of the massive substrate (105) to form the insulating layer (211) of said stack;
- transfer onto the upper part (211) of a semi-conducting layer (120) having a doping opposite that of the upper part (211) of the massive substrate (105);
- thinning of said transferred semi-conducting layer (120);
- doping of the upper face of said transferred semi-conducting layer (120) so that such transferred semi-conducting layer (120) has an upper portion (126) extending from the upper face thereof and having an opposite doping of a lower portion (128) formed by the rest of said transferred semi-conducting layer (120).

13. A method according to any of the two preceding claims, wherein said lower portion (128) is formed of a first thickness portion having a P or N doping and another also P respectively N doped thickness portion but the doping level of which is at least 100 times greater than that of the first portion and is at least equal to 1 atom of the doping species for less than 1,000 atoms of the material forming the semi-conducting layer (P+ respectively N+ doping), said other portion being located between the insulating layer (110, 211) and said first P respectively N doped thickness portion and wherein said other thickness portion is in contact with the insulating layer and with said first thickness portion.

14. A method according to any of claims 1 to 4 and 6, wherein the photovoltaic device comprises a plurality of PV cells, wherein said cycle of connection steps comprises the execution of a plurality of second electric connections (150, 471) to interconnect the PV cells of said plurality of PV cells and wherein prior to the step of forming islands (130) by etching of the semi-conducting layer (120) to form the PV cells an insulating layer (620) is positioned under the semi-conducting layer (120) and a conducting pad (625, 635), connected to the lower portion (128) of the semi-conducting layer (120) of the PV cell and extending laterally so as to have at least one first portion located under the PV cell and at least one second portion not located under the same PV cell, is formed inside the insulating layer (620) and for each PV cell;
and wherein, the execution of a plurality of second electric connections (150) to interconnect the PV cells comprises the following steps:
- opening of the insulating layer (620) under the second portion of the metallic pad (625, 635) of the PV cell, deposition of a conducting material in the opening and on a part of the side of another PV cell until the upper portion (126) of such other PV cell is reached, so as to provide an electric connection between the lower portion (128) and the upper portion (126) of two PV cells.

15. A method according to any of the preceding claims, wherein the electronic integrated circuit (170, 480) comprises transistors more particularly complementary transistors (C) of the Metal Oxide semiconductor (MOS) type and/or memories and/or batteries and/or passive devices such as capacitances or inductors.

16. A photovoltaic device comprising one or several photovoltaic cell(s) (PV cells) and at least one electronic integrated circuit (170) connected to the PV cell or to the plurality of PV cells, with the device comprising:
a substrate (105) topped with an insulating layer (110, 211, 620) and a semi-conducting layer (120) positioned on a front face of the insulating layer (110, 211, 620), with the PV cell or the plurality of PV cells being formed in said semi-conducting layer (120);
- **characterised in that** said front face of the insulating layer (110, 211, 620, 630) carries electric connections forming at least one receiving area (160) so configured as to connect at least one PV cell with at least one electronic integrated circuit (170);
- and **in that** said at least one electronic integrated circuit (170) is positioned in contact with and on the at least one receiving area (160) in front of the front face of the insulating layer (110, 211, 620).
- the at least one receiving are (160) makes it possible to connect, alone, at least one PV cell with the at least one electronic integrated circuit (170).

17. A photovoltaic device according to the preceding claim wherein the photovoltaic device comprises a plurality of photovoltaic cells (PV cells) and wherein said front face of the insulating layer (110, 211, 620, 630) carries electric connections (150) to interconnect the PV cells of said plurality of PV cells.

18. A photovoltaic device according to any of the two preceding claims comprising an additional electronic integrated circuit (480) positioned in front of a rear face (420) of the substrate (105), connected to the PV cell or to said plurality of PV cells so that said insulating layer (110, 211) is positioned between two electronic integrated circuits (170, 480).
